# EUROPEAN PATENT APPLICATION

(11) **EP 4 608 084 A1**
(43) Date of publication of application: **27.08.2025**
(21) Application number: 24203832.1
(22) Date of filing: 01.10.2024
(51) Int. Cl.: H10B 43/10, H10B 43/27, H10B 43/50

(54) **SEMICONDUCTOR DEVICE AND ELECTRONIC SYSTEM INCLUDING THE SAME**

(30) Priority: 20.02.2024 KR 20240024569
(71) Applicant: Samsung Electronics Co., Ltd, Suwon-si, Gyeonggi-do 16677 (KR)
(72) Inventor: AHN, Gwangjin, 16677 Suwon-si, Gyeonggi-do (KR); KWON, Donghoon, 16677 Suwon-si, Gyeonggi-do (KR)
(74) Representative: Kuhnen & Wacker Patent- und Rechtsanwaltsbüro PartG mbB

(57) **Abstract**

A semiconductor device includes a cell region (100) including a cell array region (102) and a connection region (104). The cell region (100) includes a gate stacking structure (102g), a channel structure (CH), a pad insulation layer (132i), and a plurality of gate contact portions (184). The gate stacking structure (102g) includes interlayer insulation layers (132m) and gate electrodes (130) alternately stacked and extending in a first direction. The channel structure (CH) passes through the gate stacking structure (102g) in the cell array region (102). The pad insulation layer (132i) is disposed in a recess portion (RP) where a partial portion of the gate stacking structure (102g) is removed to expose pad portions of the gate electrodes (130) in the connection region (104). The gate contact portions (184) pass through the pad insulation layer (132i) and are electrically connected to the gate electrodes (130), respectively. The pad insulation layer (132i) includes a corner of an obtuse angle or the pad insulation layer (132i) includes a rounded portion in a plan view.

## Description

### BACKGROUND

### (a) Field

The present disclosure relates to a semiconductor device and an electronic system including the same. More particularly, the present disclosure relates to a semiconductor device having an enhanced structure and an electronic system including the same.

### (b) Description of the Related Art

A semiconductor device may have a small size while performing various functions, and is thus widely used in various electronic industries. As advancements are made in the electronic industry, research on improving performance and an integration degree of a semiconductor device has continued. For example, the integration degree of the semiconductor device may be improved by reducing a distance between a plurality of circuit elements included in the semiconductor device.

### SUMMARY

The present disclosure attempts to provide a semiconductor device capable of improving performance and reliability and an electronic system including the same.

A semiconductor device according to an embodiment includes a cell region that includes a cell array region and a connection region. The cell region includes a gate stacking structure, a channel structure, a pad insulation layer, and a plurality of gate contact portions. The gate stacking structure includes a plurality of interlayer insulation layers and a plurality of gate electrodes alternately stacked, and extends in a first direction. The channel structure passes through the gate stacking structure in the cell array region. The pad insulation layer is disposed in a recess portion where a partial portion of the gate stacking structure is removed to expose pad portions of the plurality of gate electrodes in the connection region. The plurality of gate contact portions pass through the pad insulation layer and are electrically connected to the plurality of gate electrodes, respectively. In a plan view, the pad insulation layer includes a corner of an obtuse angle or the pad insulation layer includes a rounded portion.

A semiconductor device according to an embodiment includes a cell region that includes a cell array region and a connection region. The cell region includes a gate stacking structure, a channel structure, a pad insulation layer, and a plurality of gate contact portions. The gate stacking structure includes a plurality of interlayer insulation layers and a plurality of gate electrodes alternately stacked and extends in a first direction. The channel structure passes through the gate stacking structure in the cell array region. The pad insulation layer is disposed in a recess portion where a partial portion of the gate stacking structure is removed to expose pad portions of the plurality of gate electrodes in the connection region. The plurality of gate contact portions pass through the pad insulation layer and are electrically connected to the plurality of gate electrodes, respectively. In a plan view, an edge of at least one of the plurality of gate electrodes has a portion that is inclined to the first direction or a rounded portion.

An electronic system according to an embodiment includes a main substrate, a semiconductor device that is disposed on the main substrate, and a controller that is electrically connected to the semiconductor device on the main substrate. The semiconductor device includes a cell region that includes a cell array region and a connection region. The cell region includes a gate stacking structure, a channel structure, a pad insulation layer, and a plurality of gate contact portions. The gate stacking structure includes a plurality of interlayer insulation layers and a plurality of gate electrodes alternately stacked, and extends in a first direction. The channel structure passes through the gate stacking structure in the cell array region. The pad insulation layer is disposed in a recess portion where a partial portion of the gate stacking structure is removed to expose pad portions of the plurality of gate electrodes in the connection region. The plurality of gate contact portions pass through the pad insulation layer and are electrically connected to the plurality of gate electrodes, respectively. In a plan view, the pad insulation layer includes a corner of an obtuse angle or the pad insulation layer includes a rounded portion.

According to an embodiment, a stacking structure may be disposed in an entire region except for a partial region (such as, for example, a pad insulation layer or so on), thereby reducing an area of a semiconductor device. The semiconductor device may be a bonding semiconductor device, and thus, a defect, performance degradation, or so on that may occur in a structure that includes the stacking structure having a relatively large area may be prevented.

The pad insulation layer may have a gentle slope on a periphery of a corner and a defect that may occur on the periphery of the corner of the pad insulation layer may be prevented. Particularly, in the structure that includes the stacking structure having the relatively large area and may be vulnerable to the defect on the periphery of the corner of the pad insulation layer, the defect may be effectively prevented by a shape of the pad insulation layer. Thereby, performance and reliability of a semiconductor device may be enhanced.

### BRIEF DESCRIPTION OF THE DRAWINGS

FIG. 1 is a plan view schematically illustrating a semiconductor device according to an example embodiment.
FIG. 2 is a partial cross-sectional view schematically illustrating the semiconductor device illustrated in FIG. 1.
FIG. 3 is a partial cross-sectional view illustrating an example of a channel structure included in the semiconductor device illustrated in FIG. 2.
FIG. 4 is a partial cross-sectional view of the semiconductor device taken along a line A-A' of FIG. 1.
FIG. 5 is a plan view schematically illustrating a pad region included in the semiconductor device illustrated in FIG. 1.
FIG. 6 is an enlarged plan view illustrating a portion B of FIG. 1.
FIG. 7 is a perspective view illustrating a pad insulation layer in a portion C of FIG. 5.
FIG. 8 is a plan view schematically illustrating a pad region included in a semiconductor device according to an example embodiment.
FIG. 9 is a plan view schematically illustrating a pad region included in a semiconductor device according to an example embodiment.
FIG. 10 is a plan view schematically illustrating a pad region included in a semiconductor device according to an example embodiment.
FIG. 11 is a plan view schematically illustrating a pad region included in a semiconductor device according to an example embodiment.
FIG. 12 is a plan view schematically illustrating a pad region included in a semiconductor device according to an example embodiment.
FIG. 13 is a plan view schematically illustrating a pad region included in a semiconductor device according to an example embodiment.
FIG. 14 is a plan view schematically illustrating a pad region included in a semiconductor device according to an example embodiment.
FIG. 15 is a plan view schematically illustrating a pad region included in a semiconductor device according to an example embodiment.
FIG. 16 is a plan view schematically illustrating a pad region included in a semiconductor device according to an example embodiment.
FIG. 17 is a plan view schematically illustrating a pad region included in a semiconductor device according to an example embodiment.
FIG. 18 schematically illustrates an electronic system including a semiconductor device according to an example embodiment.
FIG. 19 is a perspective view schematically illustrating an electronic system including a semiconductor device according to an example embodiment.
FIG. 20 is a cross-sectional view schematically illustrating a semiconductor package according to an example embodiment.

### DETAILED DESCRIPTION

Embodiments of the present disclosure will be described more fully hereinafter with reference to the accompanying drawings for those skilled in the art to which the present disclosure pertains to easily practice the present disclosure. The present disclosure may be implemented in various different forms and is not limited to the embodiment provided herein.

A portion unrelated to the description is omitted in order to clearly describe the present disclosure, and the same or similar components are denoted by the same reference numeral throughout the present specification.

Further, since sizes and thicknesses of portions, regions, members, units, layers, films, or so on illustrated in the accompanying drawings may be arbitrarily illustrated for a better understanding and convenience of explanation, the present disclosure is not limited to the illustrated sizes and thicknesses. In the drawings, thicknesses of portions, regions, members, units, layers, films, or so on may be enlarged or exaggerated for convenience of explanation.

It will be understood that when a component such as a layer, film, region, or substrate is referred to as being "on" another component, it may be directly on the other component or an intervening component may also be present. In contrast, when a component is referred to as being "directly on" another component, or as "contacting" or "in contact with" another element (or using any form of the word "contact"), there are no intervening components present at the point of contact. Further, when a component is referred to as being "on" or "above" a reference component, a component may be positioned on or below the reference component, and does not necessarily be "on" or "above" the reference component toward an opposite direction of gravity.

In addition, unless explicitly described to the contrary, the word "comprise", "include", or "contain", and variations such as "comprises", "comprising", "includes", "including", "contains" or "containing" will be understood to imply the inclusion of other components rather than the exclusion of any other components.

Further, throughout the specification, a phrase "on a plane", "in a plane", "on a plan view", or "in a plan view" may indicate a case where a portion is viewed from above or a top portion, and a phrase "on a cross-section" or "in a cross-sectional view" may indicate when a cross-section taken along a vertical direction is viewed from a side.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise.

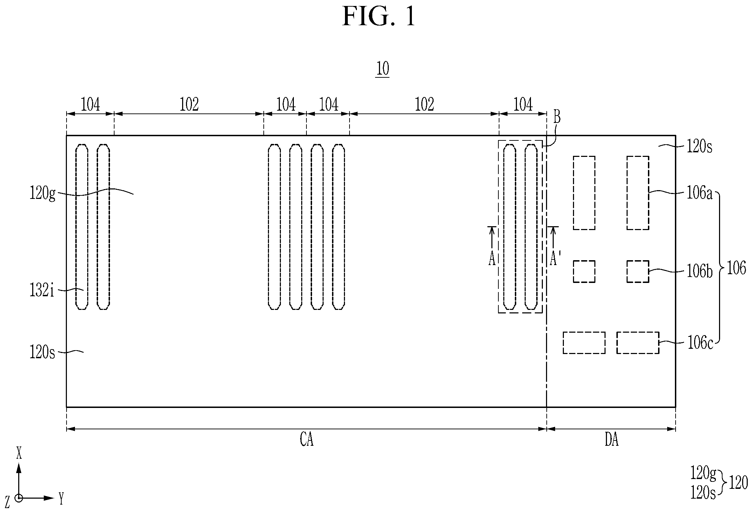

Hereinafter, with reference to FIG. 1 to FIG. 7, a semiconductor device according to an example embodiment will be described in detail.

FIG. 1 is a plan view schematically illustrating a semiconductor device 10 according to an example embodiment. FIG. 1 schematically illustrates positions of a stacking structure 120, a pad insulation layer 132i, and a pattern 106 included in a scribe region DA.

Referring to FIG. 1, a semiconductor device 10 according to an embodiment may include a chip region CA and a scribe region DA outside the chip region CA.

The chip region CA may refer to an area where a memory cell structure, a wiring portion for an operation of the memory cell structure, and a peripheral circuit structure are disposed. In the chip region CA, a cell array region 102 and a connection region 104 may be disposed. In the cell array region 102, the memory cell structure may be disposed. The connection region 104 may electrically connect the cell array region 102 to the peripheral circuit structure, or so on.

The scribe region DA may refer to an area that includes a portion to be scribed or cut when the semiconductor device 10 is divided into separate chip regions CA. The scribe region DA may be referred to as a scribe lane, a scribe line, a scribe area, an outer region, an outside region, an external region, a cut region, and/or so on.

The pattern 106 that may perform various roles may be disposed in the scribe region DA. For example, a key pattern 106a, a measurement pattern 106b, a test element group (TEG) 106c, or so on may be disposed in the scribe region DA. The key pattern 106a may include an align mark (or alignment mark) for aligning with a mask or so on used in a manufacturing process, an overlay mark for confirming an alignment of a layer formed in a previous process with a layer formed in a current process, or so on. The measurement pattern 106b may be a pattern for confirming a thickness, a critical dimension, a shape, or so on of each layer. For example, the measurement pattern 106b may include an optical pattern (e.g., optical critical dimension (OCD) pattern) or so on. The test element group 106c may be a pattern for confirming performance in a manufacturing process or after the manufacturing process.

However, the embodiments are not limited to a type of the pattern 106 that is disposed in the scribe region DA. Therefore, any of various patterns 106 that may perform various roles may be disposed in the scribe region DA.

In FIG. 1, it is illustrated as an example that the scribe region DA is disposed at one side of the chip region CA in a first direction (a Y-axis direction in the drawings), but the embodiments are not limited thereto. In some embodiments, a position of the scribe region DA may be variously modified. The connection region 104 is illustrated as an example in FIG. 1, and a position, an arrangement, or so on of the connection region 104 may be variously modified.

In an embodiment, the stacking structure 120 may be in an entire region of the chip region CA and the scribe region DA, except for a partial region of the connection region 104 or the scribe region DA that is included in the pattern 106, a pad insulation layer 132i that is disposed in the chip region CA, or so on. In this instance, the stacking structure 120 may include a gate stacking structure 120g and an insulating stacking structure 120s. The gate stacking structure 120g may be in at least a partial portion of the chip region CA, and the insulating stacking structure 120s may be in the scribe region DA and/or another portion of the chip region CA.

In the chip region CA, the stacking structure 120 may be disposed in an entire region of the chip region CA, except for a partial region such as a pad insulation layer 132i or so on. For example, in a partial portion of the chip region CA where the pad insulation layer 132i is disposed in a second direction (an X-axis direction in the drawings), the gate stacking structure 120g may be partially disposed in a portion except for the pad insulation layer 132i. In another partial portion of the chip region CA where the pad insulation layer 132i is not disposed in the second direction (the X-axis direction in the drawings), the gate stacking structure 120g may be disposed (e.g. entirely disposed). In the scribe region DA, the stacking structure 120 (more particularly, the insulating stacking structure 120s) may be in an entire region of the scribe region DA, except for the partial portion of the scribe region DA that is included in the pattern 106.

For example, a portion where the stacking structure 120 is entirely disposed from one side of the semiconductor device 10 (a left side of FIG. 1) in the first direction (the Y-axis direction in the drawings) to the other side of the semiconductor device 10 (a right side of FIG. 1) in the first direction may be provided. For example, a portion where the stacking structure 120 is entirely disposed from one side of the semiconductor device 10 (an upper side of FIG. 1) in the second direction (the X-axis direction in the drawings) to the other side of the semiconductor device 10 (a lower side of FIG. 1) in the second direction may be provided.

In an embodiment, the stacking structure 120 may be disposed in the entire portion of the chip region CA and the scribe region DA, except for the partial portion included in the connection region 104 and the partial portion that is included in the pattern 106 of the scribe region DA, and thus, an area of the semiconductor device 10 may be reduced. Unlike the embodiment, in a structure where a gate stacking structure is removed and a single insulation layer is disposed at least in a scribe region, an extra area was needed considering a process error, or so on when the gate stacking structure is removed and thus there was a limit to reducing an area of a semiconductor device.

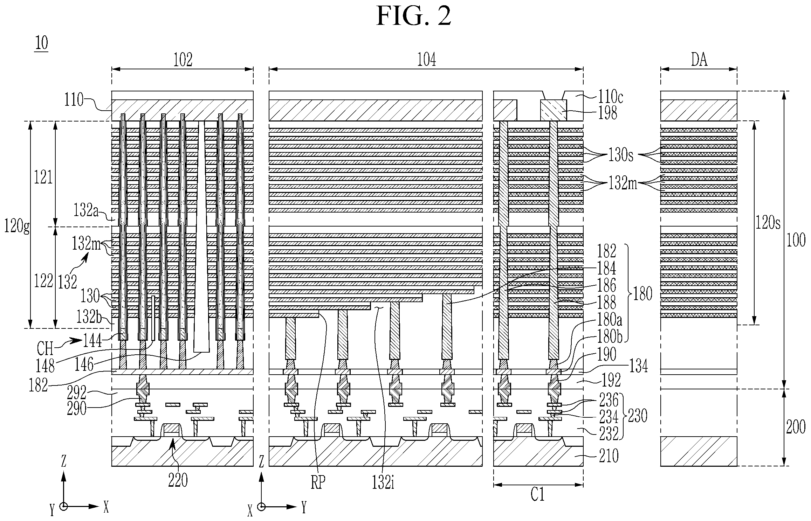

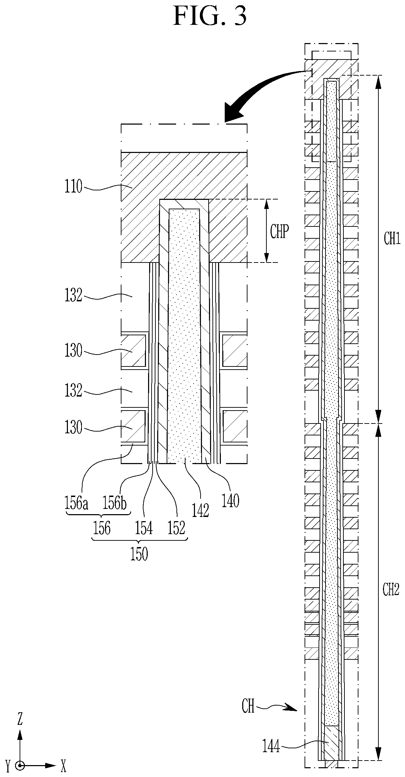

Referring to FIG. 2 and FIG. 3 together with FIG. 1, the semiconductor device 10 according to an example embodiment, and the gate stacking structure 120g and the insulating stacking structure 120s included in the same will be described in more detail.

FIG. 2 is a partial cross-sectional view schematically illustrating the semiconductor device 10 illustrated in FIG. 1. FIG. 3 is a partial cross-sectional view illustrating an example of a channel structure CH included in the semiconductor device 10 illustrated in FIG. 2. For a clear understanding, directions of FIG. 2 are illustrated based on a cell region 100, and a circuit element 220 included in a circuit region 200 is schematically illustrated.

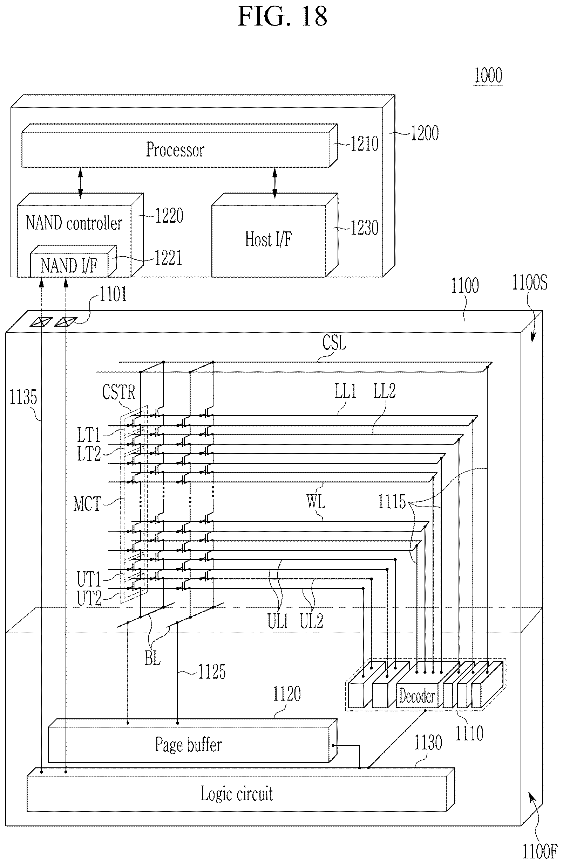

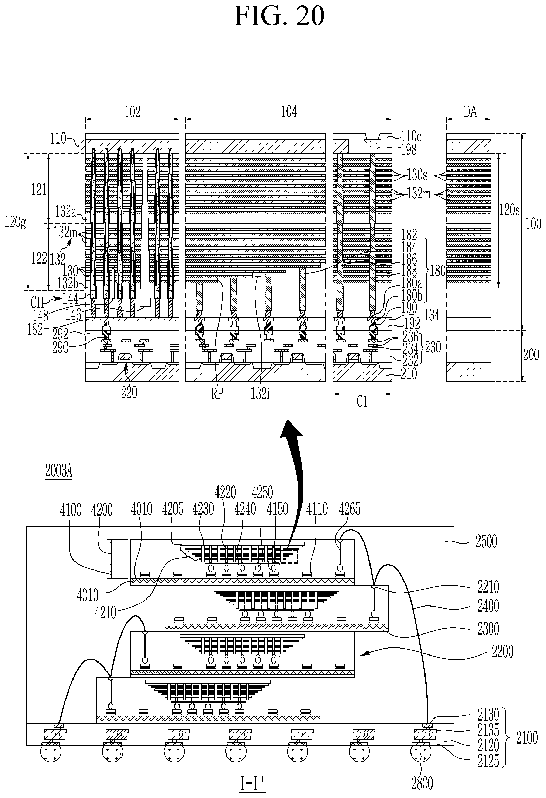

Referring to FIG. 1 to FIG. 3, the semiconductor device 10 according to an embodiment may include a cell region 100 that includes a memory cell structure and a circuit region 200 that includes a peripheral circuit structure for controlling an operation of the memory cell structure. For example, the circuit region 200 and the cell region 100 may correspond to a first structure 11 OOF and a second structure 1100S of a semiconductor device 1100 that are included in an electronic system 1000 illustrated in FIG. 18, respectively. For example, the circuit region 200 and the cell region 100 may be portions that include a first structure 4100 and a second structure 4200 of a semiconductor chip 2200 illustrated in FIG. 20, respectively.

In an embodiment, the cell region 100 may be disposed on the circuit region 200. Accordingly, an area corresponding to the circuit region 200 does not need to be secured separately from the cell region 100. Therefore, an area of the semiconductor device 10 may be reduced.

In an embodiment, the semiconductor device 10 may be a bonding semiconductor device that is formed by bonding the circuit region 200 and the cell region 100. For example, the circuit region 200 and the cell region 100 of the semiconductor device 10 may be bonded by using a hybrid bonding type. The circuit region 200 and the cell region 100 of the semiconductor device 10 may be bonded by a chip-to-chip (C2C) bonding process, a chip-to-wafer bonding process, or a wafer-to-wafer bonding process.

Thereby, the cell region 100 is formed by a process separated from a process of the circuit region 200 and thus the cell region 100 may be prevented from affecting the circuit region 200 in a manufacturing process of the cell region 100. More particularly, in the structure where the stacking structure 120 is disposed in the entire portion of the chip region CA and the scribe region DA except for a partial portion such as the pad insulation layer 132i or so on, the cell region 100 may be prevented from affecting to the circuit region 200 in the manufacturing process of the cell region 100. For example, performance of a circuit element 220 (e.g., a transistor) in the circuit region 200 may be prevented from being deteriorated due to stress caused by the stacking structure 120 in the manufacturing process of the cell region 100. For example, a crack due to thermal deformation of the stacking structure 120 may be prevented from being transferred to the circuit region 200 in the manufacturing process of the cell region 100.

However, the embodiments are not limited thereto. For example, the cell region 100 may be disposed on the circuit region 200, or the circuit region 200 may be disposed next to the cell region 100. Various other modifications are possible.

The circuit region 200 may include a first substrate 210, and a circuit element 220, a first wiring portion 230, and a first bonding structure 290 that is electrically connected to the first wiring portion 230 and is disposed at a surface facing the cell region 100. A peripheral area of the first bonding structure 290 at the surface of the circuit region 200 facing the cell region 100 may be covered by a first bonding insulation layer 292. Surfaces of the first bonding structure 290 and the first bonding insulation layer 292 may be coplanar.

The first substrate 210 may be a semiconductor substrate that includes a semiconductor material. For example, the first substrate 210 may be a semiconductor substrate that includes or is formed of a semiconductor material or may be a semiconductor substrate in which a semiconductor layer is on a base substrate. For example, the first substrate 210 may include single-crystalline or polycrystalline silicon, epitaxial silicon, germanium, silicon-germanium, silicon on insulator (SOI), germanium on insulator (GOI), or so on.

The circuit elements 220 disposed on the first substrate 210 may include any of various circuit elements and may constitute the peripheral circuit structure that controls an operation of the memory cell structure that is disposed in the cell region 100. For example, the circuit elements 220 may constitute the peripheral circuit structure such as a decoder circuit 1110 (refer to FIG. 18), a page buffer 1120 (refer to FIG. 18), a logic circuit 1130 (refer to FIG. 18), or so on.

The circuit elements 220 may include a transistor, but the embodiments are not limited thereto. For example, the circuit elements 220 may include not only an active element such as the transistor or so on but also a passive element such as a capacitor, a resistor, an inductor, or so on.

The first wiring portion 230 that is disposed on the first substrate 210 may be electrically connected to the circuit elements 220. In an embodiment, the first wiring portion 230 may include a plurality of wiring layers 236 that are spaced apart from each other while interposing an insulation layer 232 therebetween and are electrically connected by a contact via 234 to form a desired path. The wiring layer 236 or the contact via 234 may include any of various conductive materials, and the insulation layer 232 may include any of various insulating materials.

In the chip region CA, the cell region 100 may include a second substrate 110, a gate stacking structure 120g, a channel structure CH, a second wiring portion 180, and a second bonding structure 190 that is electrically connected to the second wiring portion 180 and is disposed at a surface facing the circuit region 200. A peripheral area of the second bonding structure 190 may be covered by a second bonding insulation layer 192. Surfaces of the second bonding structure 190 and the second bonding insulation layer 192 may be coplanar.

In the chip region CA, the cell region 100 may include a cell array region 102 and a connection region 104. The cell region 100 may include the gate stacking structure 120g and the channel structure CH as a memory cell structure. The gate stacking structure 120g and/or the channel structure CH may be disposed at least in the cell array region 102. A structure that connects the memory cell structure to the circuit region 200 or an external circuit may be disposed in the cell array region 102 and/or the connection region 104.

In an embodiment, the second substrate 110 may include a semiconductor layer that includes a semiconductor material. For example, the second substrate 110 may be a semiconductor substrate that includes or is formed of a semiconductor material or may be a semiconductor substrate in which a semiconductor layer is on a base substrate. For example, the second substrate 110 may include or be formed of silicon, germanium, silicon-germanium, silicon on insulator, germanium on insulator, or so on. In this instance, the second substrate 110 may include an n-type semiconductor layer including an n-type dopant (such as, for example, phosphorus (P), arsenic (As), or so on) and/or a p-type semiconductor layer including a p-type dopant (such as, for example, boron (B), gallium (Ga), or so on). In some embodiments, the second substrate 110 may include or be formed of a support member that includes an insulation layer or an insulating material. This is because, after the cell region 100 is bonded to the circuit region 200, a semiconductor substrate included in the cell region 100 may be removed and the support member that includes the insulation layer or the insulating material may be formed. However, the embodiments are not limited to a material of the second substrate 110, and a conductive type, a material, or so on of the dopant that is doped to the semiconductor layer.

The gate stacking structure 120g may include cell insulation layers 132 and gate electrodes 130 alternately stacked on a surface (e.g., a lower surface in FIG. 2) of the second substrate 110. The channel structure CH may extend in an extension direction that crosses the second substrate 110 and pass through the gate stacking structure 120g. For example, the extension direction of the channel structure CH may be a direction that crosses the second substrate 110 (e.g., a vertical direction that is perpendicular to the second substrate 110) and may be a Z-axis direction in the drawings.

The gate electrode 130 may include any of various conductive materials. For example, the gate electrode 130 may include a metal material (e.g., tungsten (W), copper (Cu), aluminum (Al), or so on), polycrystalline silicon, metal nitride (e.g., titanium nitride (TiN), tantalum nitride (TaN), or so on), or a combination thereof. The cell insulation layer 132 may include any of various insulating materials. For example, the cell insulation layer 132 may include silicon oxide, silicon nitride, silicon oxynitride, a low dielectric constant material having a lower dielectric constant than silicon oxide, or a combination thereof.

The channel structure CH may include a channel layer 140, and a gate dielectric layer 150 that is disposed on the channel layer 140 between the gate electrode 130 and the channel layer 140. For example, the gate dielectric layer 150 may contact a side surface of the channel layer 140. The gate dielectric layer 150 that is disposed between the gate electrode 130 and the channel layer 140 may include a tunneling layer 152, a charge storage layer 154, and a blocking layer 156 that are sequentially disposed on the channel layer 140.

The channel structure CH may further include a core insulation layer 142 that is disposed inside the channel layer 140. The channel layer 140 may contact a side surface of the core insulation layer 142. In some embodiments, the core insulation layer 142 might not be provided. The channel structure CH may further include a channel pad 144 that is disposed on the channel layer 140 and/or the gate dielectric layer 150. The channel pad 144 may cover an upper surface of the core insulation layer 142 (a lower surface in FIG. 2) and be disposed to be electrically connected to the channel layer 140.

Each channel structure CH may form one memory cell string, and a plurality of channel structures CH may be spaced apart from each other while forming rows and columns in a plan view. For example, in a cross-sectional view, the channel structure CH may have an inclined side surface so that a width of the channel structure CH decreases as the channel structure CH extends toward the second substrate 110 according to a high aspect ratio. However, the embodiments are not limited thereto, and an arrangement, a structure, a shape, or so on of the channel structure CH may be variously modified.

The channel layer 140 may include a semiconductor material (e.g., polycrystalline silicon). The core insulation layer 142 may include any of various insulating materials. For example, the core insulation layer 142 may include silicon oxide, silicon nitride, silicon oxynitride, or a combination thereof. The channel pad 144 may include a conductive material (e.g., polycrystalline silicon doped with a dopant).

The tunneling layer 152 may include an insulating material that is capable of tunneling a charge (e.g., silicon oxide, silicon oxynitride, or so on). The charge storage layer 154 may be used as a data storage region, and the charge storage layer 154 may include polycrystalline silicon, silicon nitride, or so on. The blocking layer 156 may include an insulating material that is capable of preventing an undesirable flow of charge into the gate electrode 130. For example, the blocking layer 156 may include, for example, silicon oxide, silicon nitride, silicon oxynitride, a high dielectric constant material having a higher dielectric constant than silicon oxide, or a combination thereof. In an embodiment, the blocking layer 156 may include a first blocking layer 156a that includes a portion horizontally extending on the gate electrode 130, and a second blocking layer 156b that vertically extend between the first blocking layer 156a and the charge storage layer 154.

However, the embodiments are not limited to a material, a structure, or so on of the channel layer 140, the core insulation layer 142, and the gate dielectric layer 150.

In an embodiment, the channel structure CH may include a protruding portion CHP that protrudes to an inside of the second substrate 110. The gate dielectric layer 150 might not be disposed at the protruding portion CHP and the channel layer 140 that is disposed at the protruding portion CHP may be electrically connected to the second substrate 110. For example, the second substrate 110 may contact side and upper surfaces of the channel layer 140. However, the embodiments are not limited thereto, and an electrical connection structure between the channel structure CH and the second substrate 110 may have any of various structures.

In an embodiment, the gate stacking structure 120g may be sequentially stacked on a lower portion of the second substrate 110 in the drawings. The channel structure CH that passes through the gate stacking structure 120g may be disposed at a lower portion of the second substrate 110 in the drawings. In a cross-sectional view, the channel structure CH may have an inclined side surface such that a width of the channel structure CH decreases from the circuit region 200 toward the second substrate 110. The channel pad 144 and the second wiring portion 180 that are disposed at an upper portion (a lower portion in the drawings) of the gate stacking structure 120g may be adjacent to the circuit region 200.

In an embodiment, the gate stacking structure 120g may include a plurality of stacking portions 121 and 122 that are sequentially stacked on the second substrate 110. Thereby, a number of stacked gate electrodes 130 may be increased and thus a number of memory cells may be increased with a stable structure. Accordingly, a data storage capacity of the semiconductor device 10 may be increased. In FIG. 2, it is illustrated as an example that the gate stacking structure 120g includes first and second stacking portions 121 and 122. However, the embodiments are not limited thereto. In some embodiments, the gate stacking structure 120g may include one stacking portion or three or more stacking portions.

When the plurality of stacking portions 121 and 122 are provided as in the above, the channel structure CH may include a plurality of channel portions CH1 and CH2 that respectively pass through the plurality of stacking portions 121 and 122. The plurality of channel portions CH1 and CH2 may be connected to each other. In a cross-sectional view, each of the plurality of channel portions CH1 and CH2 may have an inclined side surface such that a width of each of the plurality of channel portions CH1 and CH2 decreases toward the second substrate 110 according to an aspect ratio. A bent portion due to a difference in widths of the plurality of channel portions CH1 and CH2 may be provided at a connection portion of the plurality of channel structures CH1 and CH2. In some embodiments, the plurality of channel portions CH1 and CH2 may have an inclined side surface that is continuously extended without the bent portion. In FIG. 3, it is illustrated as an example that gate dielectric layers 150, channel layers 140, and core insulation layers 142 of the plurality of channel portions CH1 and CH2 continuously extend to have an integral structure. However, the embodiments are not limited thereto. In some embodiments, the gate dielectric layers 150, the channel layers 140, or the core insulation layers 142 of the plurality of channel portions CH1 and CH2 may be separately formed and be electrically connected to each other. In some embodiments, a separate channel pad may be additionally disposed at the connection portion of the plurality of channel portions CH1 and CH2. As such, the embodiments are not limited to a shape of the plurality of channel portions CH1 and CH2.

In an embodiment, the cell insulation layer 132 may include an interlayer insulation layer 132m and an upper insulation layer 132a or 132b. The interlayer insulation layer 132m may be disposed between two gate electrodes 130 adjacent to each other in each of the plurality of stacking portions 121 and 122. The upper insulation layers 132a and 132b may be disposed at upper surfaces of the plurality of stacking portions 121 and 122, respectively. In an embodiment, thicknesses of the plurality of cell insulation layers 132 might not be the same. For example, a thickness of the upper insulation layer 132a or 132b may be greater than a thickness of the interlayer insulation layer 132m. However, the embodiments are not limited thereto, and a shape, a structure, or so on of the cell insulation layer 132 may be variously modified.

In an embodiment, in a plan view, the gate stacking structure 120g may be divided into a plurality of portions by a separation structure 146. The separation structure 146 may extend in a direction that crosses the second substrate 110 (the Z-axis direction in the drawings) or the vertical direction and passes through the gate stacking structure 120g. An upper separation region 148 may be disposed at an upper portion (a lower portion in FIG. 2) of the gate stacking structure 120g. In a plan view, the separation structure 146 and/or the upper separation region 148 may extend in the first direction (the Y-axis direction in the drawings). A plurality of separation structures 146 and/or a plurality of upper separation regions 148 may be spaced apart from each other at predetermined intervals in the second direction (the X-axis direction in the drawings).

In a plan view, the plurality of gate stacking structures 120g may each extend in the first direction (the Y-axis direction of the drawing) and be spaced apart from each other at a predetermined interval in the second direction (the X-axis direction of the drawing) by the separation structure 146. The gate stacking structure 120g that is divided by the separation structure 146 may constitute one memory cell block. However, the embodiments are not limited thereto, and a range of the memory cell block is not limited thereto.

For example, the separation structure 146 may pass through the gate stacking structure 120g and extend to the second substrate 110, and the upper separation region 148 may separate one or a part of the plurality of gate electrodes 130. The upper separation region 148 may be disposed between the separation structures 146.

For example, in a cross-sectional view, the separation structure 146 may have an inclined side surface such that a width of the separation structure 146 gradually decreases toward the second substrate 110 due to a high aspect ratio. However, the embodiments are not limited thereto. A side surface of the separation structure 146 may be perpendicular to the second substrate 110, or the separation structure 146 may have a bent portion at the connection portion of the first and second stacking portions 121 and 122.

The separation structure 146 and/or the upper separation region 148 may include or be filled with any of various insulating materials. For example, the separation structure 146 or the upper separation region 148 may be formed of or include an insulating material such as silicon oxide, silicon nitride, or silicon oxynitride. However, the embodiments are not limited thereto, and a structure, a shape, a material, or so on of the separation structure 146 or the upper separation region 148 may be variously modified.

The connection region 104 and the second wiring portion 180 may be provided to connect the gate stacking structure 120g and the channel structure CH in the cell array region 102 to the circuit region 200 or an external circuit. The connection region 104 may be disposed at a periphery of the cell array region 102 and at least a partial portion of the second wiring portion 180 may be in the connection region 104.

In an embodiment, the second wiring portion 180 may include a member that electrically connects the gate electrode 130, the channel structure CH, and/or the second substrate 110 to the circuit region 200 or the external circuit. For example, the second wiring portion 180 may include a bit line 182, a gate contact portion 184, a source contact portion 186, an input/output connection wiring 188, a contact via 180a, and a connection wiring 180b. The contact via 180a may be connected to each of the bit line 182, the gate contact portion 184, the source contact portion 186, and/or the input/output connection wiring 188. For example, the contact vias 180a may contact each of the bit line 182, the gate contact portion 184, the source contact portion 186, and/or the input/output connection wiring 188. In example embodiments, the contact vias 180a may contact the connection wiring 180b. The connection wiring 180b may be electrically connected to the bit line 182, the gate contact portion 184, the source contact portion 186, the input/output connection wiring 188, and/or the contact via 180a.

The bit line 182 may extend lengthwise in the second direction (the X-axis direction in the drawings) that is transverse to the first direction. The bit line 182 may be electrically connected to the channel structure CH (e.g., the channel pad 144) through the contact via 180a (e.g., a bit line contact via).

In the connection region 104, the plurality of gate electrodes 130 may extend in the first direction (the Y-axis direction in the drawings). Extension lengths of the plurality of gate electrodes 130 may sequentially decrease in a direction away from the second substrate 110. For example, the plurality of gate electrodes 130 may have a stair shape in one direction or a plurality of directions in the connection region 104. In the connection region 104, a plurality of gate contact portions 184 may pass through the cell insulation layer 132 (e.g., the pad insulation layer 132i) to be electrically connected to the plurality of gate electrodes 130, respectively, that are extended to the connection region 104.

The source contact portion 186 may be electrically connected to a common source line. In FIG. 2, it is illustrated as an example that the source contact portion 186 is connected to the second substrate 110 that constitutes at least a partial portion of the common source line. However, the embodiments are not limited thereto. In some embodiments, a source connecting portion may be provided at a side of an outer surface of the second substrate 110. The source connecting portion may be connected to the second substrate 110 through a through via that passes through an outer insulation layer 110c. In this instance, the source contact portion 186 may be connected to the source connecting portion through the through via or be directly connected to the source connecting portion. The source connecting portion may include or be formed of a conductive material that has an electrical resistance less than an electrical resistance of the second substrate 110. By providing the source connecting portion having the electrical resistance less than the electrical resistance of the second substrate 110, an electrical connection path that has a low electrical resistance may be provided. However, the embodiments are not limited thereto, and an electrical connection structure between the source contact portion 186 and the common source line may be variously modified.

The input/output connection wiring 188 may be electrically connected to an input/output pad 198. The input/output connection wiring 188 may be electrically connected to a part of the second bonding structures 190. For example, the input/output pad 198 may be disposed at a side where the second substrate 110 is disposed. In some embodiments, an additional input/output pad that is electrically connected to the circuit region 200a may be provided.

The connection wiring 180b may be disposed in the cell array region 102 and/or the connection region 104. The bit line 182, the gate contact portion 184, the source contact portion 186, and/or the input/output connection wiring 188 may be electrically connected to the connection wiring 180b. For example, the gate contact portion 184, the source contact portion 186, and/or the input/output connection wiring 188 may be electrically connected to the connection wiring 180b through the contact via 180a.

In FIG. 2, it is illustrated as an example that the connection wiring 180b is a single layer on the same plane as the bit line 182 and an additional insulation layer 134 is at a portion other than the connection wiring 180b. However, this is brief illustration for convenience. For an electrical connection with the bit line 182, the gate contact portion 184, the source contact portion 186, and/or the input/output connection wiring 188, the connection wiring 180b may include a plurality of wiring layers and may further include a contact via.

The cell region 100 may include the second bonding structure 190 that is electrically connected to the second wiring portion 180 and is disposed at the surface facing the circuit region 200. A peripheral area of the second bonding structure 190 that is disposed at the surface of the cell region 100 facing the circuit region 200 may be covered by the second bonding insulation layer 192.

The circuit region 200 and the cell region 100 may be bonded by hybrid bonding. More particularly, the circuit region 200 and the cell region 100 may be bonded by the hybrid bonding that includes metal bonding between the first bonding structure 290 and the second bonding structure 190 and insulation-layer bonding between the first bonding insulation layer 292 and the second bonding insulation layer 192.

For example, the first bonding structure 290 and/or the second bonding structure 190 may be formed of or include at least one of copper, aluminum, tungsten, nickel, gold, tin, manganese, cobalt, titanium, tantalum, ruthenium, or beryllium, or an alloy including the same. For example, the first and second bonding structures 290 and 190 may be formed of or include copper so that the cell region 100 and the circuit region 200 may be bonded (e.g., directly bonded) to each other by copper-to-copper bonding.

For example, at an insulation-layer bonding surface, the first bonding insulation layer 292 and the second bonding insulation layer 192 may be formed of or include the same insulating material. For example, the first bonding insulation layer 292 and/or the second bonding insulation layer 192 may include a layer that includes silicon carbonitride at least at the bonding surface. However, the embodiments are not limited thereto. The first bonding insulation layer 292 and/or the second bonding insulation layer 192 may include the same material as or a different material from the cell insulation layer 132 or the additional insulation layer 134 in the cell region 100 or the insulation layer 232 in the circuit region 200.

In an embodiment, by the second wiring portion 180, the second bonding structure 190, the first bonding structure 290, and the first wiring portion 230, the bit line 182 connected to the channel structure CH, the gate electrode 130, and/or the second substrate 110 may be electrically connected to the circuit element 220 of the circuit region 200.

In FIG. 2, it is illustrated as an example that, in a cross-sectional view, each of the gate contact portion 184, the source contact portion 186, and/or the input/output connection wiring 188 has an inclined side surface such that a width of each of the gate contact portion 184, the source contact portion 186, and/or the input/output connection wiring 188 decreases toward the second substrate 110 due to an aspect ratio and a bent portion is provided at a boundary portion of the plurality of stacking portions 121 and 122. However, the embodiments are not limited thereto. In some embodiments, the gate contact portion 184, the source contact portion 186, and/or the input/output connection wiring 188 might not include the bent portion at the boundary portion of the plurality of stacking portions 121 and 122. In some embodiments, in a cross-sectional view, the input/output connection wiring 188 may have an inclined side surface such that a width of the input/output connection wiring 188 decreases toward the circuit region 200. Other various modifications are possible.

In the scribe region DA, the cell region 100 may include the insulating stacking structure 120s at a position corresponding to the gate stacking structure 120g. In the scribe region DA, the second substrate 110, the additional insulation layer 134, and/or the second bonding insulation layer 192 may be provided.

The insulating stacking structure 120s may include the plurality of cell insulation layers 132 (e.g., the plurality of interlayer insulation layers 132m) and a plurality of sacrificial insulation layers 130s alternately stacked. The sacrificial insulation layer 130s may include a material that is different from a material of the cell insulation layer 132 (e.g., the interlayer insulation layer 132m). For example, the sacrificial insulation layer 130s may include or be formed of silicon, silicon oxide, silicon carbide, silicon nitride, or so on and may include or be formed of a material that is different from a material of the cell insulation layer 132. The plurality of interlayer insulation layers 132m of the gate stacking structure 120g and the plurality of interlayer insulation layers 132m of the insulating stacking structure 120s may be formed by the same process. In the chip region CA and the scribe region DA, the insulating stacking structure 120s may be formed by alternately stacking the plurality of interlayer insulation layers 132m and the plurality of sacrificial insulation layers 130s, and then, the plurality of sacrificial insulation layers 130s that are disposed at least in a partial portion of the chip region CA may be selectively removed and the gate electrodes 130 may be formed at portions where the plurality of sacrificial insulation layers 130s were removed. Thereby, the gate stacking structure 120g that includes the plurality of interlayer insulation layers 132m and the plurality of gate electrodes 130 alternately stacked may be disposed at least in the partial portion of the chip region CA, and the insulating stacking structure 120s that includes the plurality of interlayer insulation layers 132m and the plurality of sacrificial insulation layers 130s alternately stacked may be disposed in the scribe region DA.

The insulating stacking structure 120s may refer to a portion that includes the cell insulation layer 132 including an insulating material and the sacrificial insulation layer 130s including a material different from the insulating material of the cell insulation layer 132. When the sacrificial insulation layer 130s includes an insulating material, the stacking structure that includes the cell insulation layers 132 and the sacrificial insulation layers 130s may be referred to as the insulating stacking structure 120s. Further, when the sacrificial insulation layer 130s includes a non-insulating material (e.g., silicon), the stacking structure that includes the cell insulation layers 132 and the sacrificial insulation layers 130s may be referred to as the insulating stacking structure 120s because the stacking structure includes the cell insulation layers 132 that includes an insulating material. The insulating stacking structure 120s may be referred to as a stacked structure, a preliminary stacking structure, or so on.

In FIG. 2, it is illustrated as an example that the insulating stacking structure 120s is disposed in a portion C1 of the chip region CA where the source contact portion 186 and the input/output connection wiring 188 are disposed. Thereby, an insulation of the source contact portion 186 and the input/output connection wiring 188 may be secured by the insulating stacking structure 120s and a manufacturing process may be easy. However, the embodiments are not limited thereto. In some embodiments, an insulation structure that has a structure different from a structure of the insulating stacking structure 120s may be disposed in the portion C1 of the chip region CA where the source contact portion 186 and the input/output connection wiring 188 are disposed.

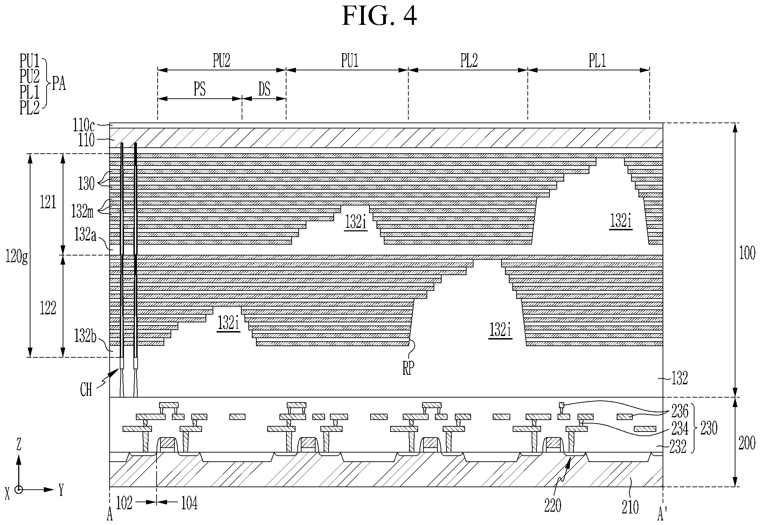

In an embodiment, a recess portion RP may be disposed in the connection region 104. The recess portion RP may be a portion where a partial portion of the gate stacking structure 120g is removed for an electrical connection between the plurality of gate electrodes 130 that are included in the gate stacking structure 120g and the plurality of gate contact portions 184. The recess portion RP may include or be filled with the pad insulation layer 132i. Referring to FIG. 4 together with FIG. 1 to FIG. 3, the recess portion RP and the pad insulation layer 132i will be described in detail.

FIG. 4 is a partial cross-sectional view of the semiconductor device 10 taken along a line A-A' of FIG. 1. For a clear understanding and simple illustration, FIG. 4 illustrates a portion where the gate contact portion 184 is not disposed.

Referring to FIG. 1 to FIG. 4, in a pad region PA, a plurality pad portions of the plurality of gate electrodes 130 may be sequentially exposed by the recess portion RP that is disposed at the gate stacking structure 120g. The pad portion of the gate electrode 130 may be a portion that is disposed at a side of an end portion of the gate electrode 130.

For example, in a pad section PS of the pad region PA, the plurality of gate electrodes 130 may be sequentially removed by the recess portion RP. For example, at each level, a portion of the gate electrode 130 may be removed to expose an end of the underlying gate electrode 130, resulting in the gate electrodes 130 becoming increasingly shorter as the distance increases from the second substrate 110. In an embodiment, in the pad section PS, extension lengths of the plurality of gate electrodes 130 in a direction away from the cell array region 102 may sequentially increase toward the second substrate 110. For example, the plurality of gate electrodes 130 may have a stair shape in the pad section PS. In this instance, the plurality of gate electrodes 130 may have a stair shape in one direction or a plurality of directions. Thereby, the pad portions of the plurality of gate electrodes 130 may be exposed to an upper portion (a lower portion of FIG. 2) in the pad section PS.

In a dummy section DS of the pad region PA, the plurality of gate electrodes 130 may be sequentially removed by the recess portion RP. In an embodiment, in the dummy section DS, extension lengths of the plurality of gate electrodes 130 in a direction toward the cell array region 102 may sequentially increase toward the second substrate 110. For example, the plurality of gate electrodes 130 may have a stair shape in the dummy section DS. The stair shape of the plurality of gate electrodes 130 in the dummy section DS may have a slope greater than a slope of the stair shape of the plurality of gate electrodes 130 in the pad section PS, but the embodiments are not limited thereto.

The recess portion RP of the pad region PA may have a shape or a profile that is configured to sequentially expose the plurality of pad portions of the plurality of gate electrodes 130 in the pad region PA. The shapes or the profiles of the recess portions RP in the pad section PS and the dummy section DS of the pad region PA may be the same as or similar to each other. The shapes or the profiles of the gate electrodes 130 in the pad section PS and the dummy section DS of the pad region PA may be the same as or similar to each other.

In FIG. 4, it is illustrated as an example that each of the plurality of pad regions PA includes a first pad region PU1 and PL1 and a second pad region PU2 and PL2. In the first pad region PU1 or PL1, the gate electrodes 130 of the first stacking portion 121 and the gate contact portions 184 may be connected, respectively. In the second pad region PU2 or PL2, the gate electrodes 130 of the second stacking portion 122 and the gate contact portions 184 may be connected, respectively. The pad region PA may include an upper pad region PU1 or PU2 that is disposed at an upper portion of the first stacking portion 121 or the second stacking portion 122, and a lower pad region PL1 or PL2 that is disposed at a lower portion of the first stacking portion 121 or the second stacking portion 122. When each of the plurality of stacking portions 121 and 122 includes the plurality of pad regions PA (e.g., the upper pad region PU1 or PU2 and the lower pad region PL1 or PL2), a manufacturing process of the recess portion RP or the gate electrodes 130 that have the stair shape may be simplified. However, the embodiments are not limited thereto, and each stacking portion 121 or 122 may include one pad region PA or three or more pad regions PA.

In FIG. 4, it is illustrated as an example that the second upper pad region PU2, the first upper pad region PU1, the second lower pad region PL2, and the first lower pad region PL1 are sequentially disposed in a direction away from the cell array region 102. However, the embodiments are not limited thereto.

The pad insulation layer 132i that covers the gate stacking structure 120g in the recess portion RP may be disposed. The pad insulation layer 132i may constitute a partial portion of the upper insulation layer 132a or 132b, or may be separately included from the upper insulation layer 132a or 132b.

The gate contact portion 184 may include or be formed of a conductive material, for example, tungsten (W), copper (Cu), aluminum (Al), or so on, and may further include a diffusion barrier layer. However, the embodiments are not limited to a material of the gate contact portion 184.

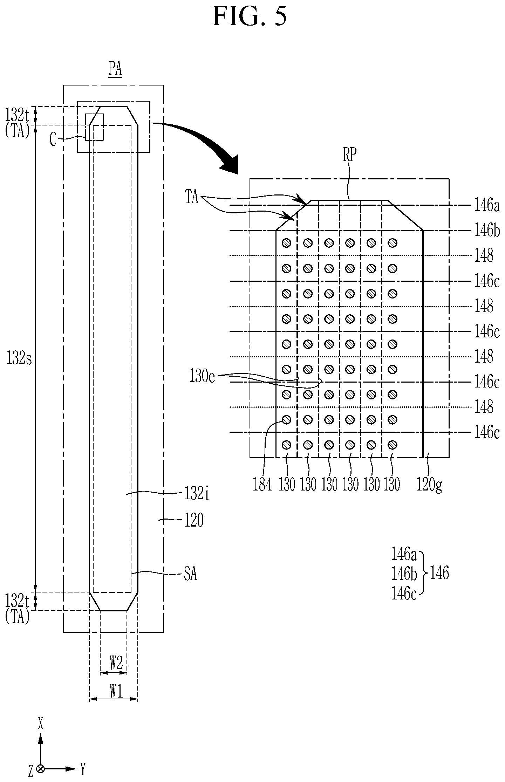

Referring to FIG. 5 to FIG. 7 together with FIG. 1 to FIG. 4, a connection structure between the gate electrodes 130 and the gate contact portions 184 in the pad region PA, and a shape of the pad insulation layer 132i according to an example embodiment will be described in detail.

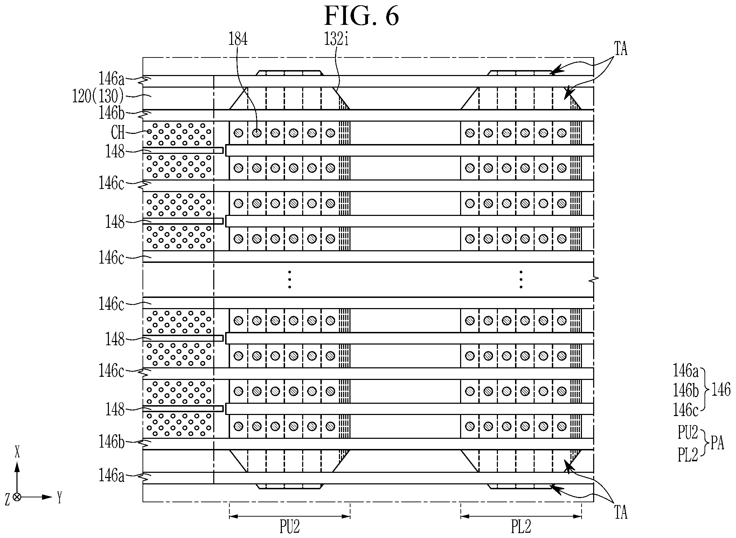

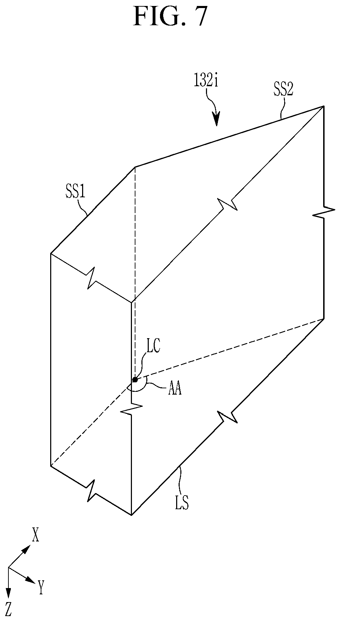

FIG. 5 is a plan view schematically illustrating the pad region PA included in the semiconductor device 10 illustrated in FIG. 1. FIG. 6 is an enlarged plan view illustrating a portion B of FIG. 1. FIG. 7 is a perspective view illustrating the pad insulation layer 132i in a portion C of FIG. 5.

In a left portion of FIG. 5, positions of the stacking structure 120 (e.g., the gate stacking structure 120g), the pad insulation layer 132i, and a contact area SA at an upper surface (a lower surface in FIG. 2 or FIG. 4) of the stacking structure 120 (e.g., the gate stacking structure 120g) are mainly illustrated, and the gate contact portions 184 are not illustrated. In an enlarged view in a right portion of FIG. 5, positions of the pad portions of the plurality of gate electrodes 130, the plurality of gate contact portions 184 that are electrically connected to the plurality of gate electrodes 130, respectively, the separation structure 146, and the upper separation region 148 in the pad region PA are schematically illustrated. For simple illustration and a clear understanding, in the enlarged view in the right portion of FIG. 5, edges of the plurality of gate electrodes 130 in the pad section PS (refer to FIG. 4) are illustrated, while other edges of the plurality of gate electrodes 130 in the dummy section DS (refer to FIG. 4) are not illustrated. FIG. 6 illustrates the upper surface (the lower surface of FIG. 2 or FIG. 4) of the stacking structure 120 (e.g., the gate stacking structure 120g).

Referring to FIG. 1 to FIG. 7, in a plan view, the pad region PA or the pad insulation layer 132i may include a contact area SA. In the contact area SA, the plurality of gate contact portions 184 may be disposed. The contact area SA may refer to an area defined by connecting outer edges of the plurality of gate contact portions 184. In a plan view, the pad region PA or the pad insulation layer 132i may further include a dummy area TA that is disposed in a region other than the contact area SA in the second direction (the X-axis direction in the drawings). The dummy area TA may refer to an area where the gate contact portion 184 or so on is not disposed, considering a process error in an etching process, a process that replaces the sacrificial insulation layer 130s to the gate electrode 130, or so on. In an area of the cell array region 102 that corresponds to the dummy area TA in the second direction, the channel structure CH might not be provided. For example, the dummy area TA may be disposed at both ends of the pad region PA or the pad insulation layer 132i in the second direction. A process margin may be secured by the dummy area TA, and the gate electrode 130 and the gate contact portion 184 may be stably electrically connected in the contact area SA.

The dummy area TA may correspond to an area outside an outermost separation structure 146a among the plurality of separation structures 146 in the second direction (the X-axis direction in the drawings) and/or an area between the outermost separation structure 146a and a first inner separation structure 146b that is adjacent to the outermost separation structure 146a in the second direction. In the contact area SA, inner separation structures 146b and 146c (i.e., the first inner separation structure 146b that is adjacent to the outermost separation structure 146a and second inner separation structures 146c that are other than the first inner separation structure 146b) may be disposed. In the drawings, one first inner separation structure 146b is illustrated as an example. In some embodiments, a plurality of first inner separation structures 146b may be included and thus the dummy area TA may include a portion that is disposed between the plurality of first inner separation structures 146b. Other various modifications are possible.

An area between the outermost separation structure 146a and the first inner separation structure 146b may correspond to the dummy area TA, and the upper separation region 148 might not be disposed between the outermost separation structure 146a and the first inner separation structure 146b. In the second direction (the X-axis direction in the drawings), the upper separation region 148 may be disposed between the first inner separation structure 146b and the second inner separation structure 146c, or between two second inner separation structures 146b that are adjacent to each other.

In an embodiment, in a plan view, the pad insulation layer 132i may include a main portion 132s that corresponds to the contact area SA and end portions 132t that are disposed at both ends of the main portion 132s in the second direction to correspond to the dummy area TA.

In an embodiment, the main portion 132s may include a portion that has a first width in the first direction (the Y-axis direction in the drawings) and longitudinally extends in the second direction (the X-axis direction in the drawings). A width of the end portion 132t in the first direction may gradually decrease toward an end in the second direction. That is, the end portion 132t may be a width changing portion where the width changes. In the drawings, it is illustrated as an example that a width of an entire portion of the main portion 132s is uniform in the second direction and the main portion 132s does not include the width changing portion. In some embodiments, a partial portion of the main portion 132s may include the width changing portion.

In this instance, in a plan view, a corner of the pad insulation layer 132i may have an obtuse angle. More particularly, in a plan view, a partial portion of the pad insulation layer 132i where the main portion 132s and the end portion 132t are connected may have an obtuse angle. Accordingly, in at least one of a plurality of portions of the pad insulation layer 132i that are disposed on the plurality of gate electrodes 130, a first side surface SS1 of the pad insulation layer 132i and a second side surface SS2 of the pad insulation layer 132i may be connected to have an obtuse angle.

More particularly, as in the above, in the pad region PA, the gate stacking structure 120g (e.g., the plurality of gate electrodes 130) may have the stair shape. Accordingly, the pad insulation layer 132i may include the plurality of portions that are disposed on the plurality of gate electrodes 130 having the stair shape. A corner LC of each of the plurality of portions of the pad insulation layer 132i may be a triple point where a bottom surface LS, and the first side surface SS1 and the second side surface SS2 that cross the bottom surface LS meet. Here, the bottom surface LS of the pad insulation layer 132i may refer to a surface that is adjacent to the gate electrode 130.

A corner LC of the pad insulation layer 132i has the obtuse angle in a plan view, and the first side surface SS1 and the second side surface SS2 may meet to have the obtuse angle at the corner LC of at least one of the plurality of portions of the pad insulation layer 132i. For example, an angle AA between the first side surface SS1 that has a flat surface and the second side surface SS2 that has a flat surface may be the obtuse angle. Thereby, the corner LC of the pad insulation layer 132i may have a gentle slope, and a defect that may occur on the periphery of the corner LC of the pad insulation layer 132i may be prevented or minimized. Accordingly, performance of the semiconductor device 10 may be enhanced.

For reference, in a comparative embodiment where a first side surface and a second side surface of a pad insulation layer meet to have a relatively small angle (e.g., an acute angle or a right angle), a pad insulation layer is not stably formed on a periphery of a corner of the pad insulation layer and thus a defect (e.g., cusping) where a gap occurs on the periphery of the corner may be generated. The defect may cause various problems in a subsequent process. For example, a metal material or so on used in a subsequent process may remain in the gap of the pad insulation layer and a property of a semiconductor device may be deteriorated. On the other hand, in an embodiment, the corner LC of the pad insulation layer 132i may have the gentle slope and the defect that may occur on the periphery of the corner LC may be prevented or minimized.

In an embodiment, in a plan view, the pad insulation layer 132i may include a plurality of corners LC, and each of the plurality of corners LC may have the obtuse angle. Thereby, the pad insulation layer 132i may be stably formed and the defect that may occur on the periphery of the corner LC of the pad insulation layer 132i may be prevented or minimized. For example, in a plan view, the pad insulation layer 132i may have five or more (e.g., six or more) corners LC, and each of the plurality of corners LC may have the obtuse angle.

In FIG. 5 and FIG. 6, it is illustrated as an example that a width of the end portion 132t in the first direction may gradually decrease from the first width W1 to a second width W2 as it goes from a portion that is adjacent to the main portion 132s to a portion that is far away from the main portion 132s. In a plan view, the pad insulation layer 132i may have an octagonal shape, and each of the plurality of corners LC (eight corners) of the pad insulation layer 132i may have an obtuse angle. However, the embodiments are not limited thereto.

In a plan view, the outermost separation structure 146a may be spaced apart from an edge of the pad insulation layer 132i in the second direction and may cross the width changing portion or the end portion 132t of the pad insulation layer 132i. The first inner separation structure 146b may cross the width changing portion or the end portion 132t of the pad insulation layer 132i. In FIG. 5, it is illustrated as an example that the first inner separation structure 146b may be disposed at a boundary between the end portion 132t and the main portion 132s of the pad insulation layer 132i or at a boundary between the width changing portion and a portion having the uniform first width W1. Thereby, in an embodiment, a portion corresponding to the width changing portion having a relatively small width may be used as the dummy area TA, and the pad insulation layer 132i may have the obtuse angle in a plan view without an area loss. However, the embodiments are not limited thereto, and the first inner separation structure 146b may cross the portion having the uniform first width W1 or the main portion 132s of the pad insulation layer 132i.

For example, in the second direction (the X-axis direction in the drawings), a length of the dummy area TA or a length of the end portion 132t may be less than the first width W1 of the pad insulation layer 132i. However, the embodiments are not limited thereto.

In an embodiment, the contact area SA may have a rectangular shape that has a predetermined width in the first direction (the Y-axis direction in the drawings) and longitudinally extends in the second direction (the X-axis direction in the drawings). For example, the contact area SA may have a width or an area less than a width or an area of the main portion 132s and may have a shape that is the same as or corresponds to a shape of the main portion 132s.

Each of edges 130e of the plurality of gate electrodes 130 in the contact area SA or the pad insulation layer 132i may longitudinally extend in a direction perpendicular to the first direction (the Y-axis direction of the drawing). That is, each of the edges 130e of the plurality of gate electrodes 130 may be parallel to the second direction (the X-axis direction in the drawings). In this instance, the edges 130e of the plurality of gate electrodes 130 may be parallel to at least one edge of the main portion 132s. More particularly, the edges 130e of the plurality of gate electrodes 130 may be parallel to an edge (a left edge in FIG. 5) of the main portion 132s that is adjacent to the cell array region 102 in the first direction.

An interval between the plurality of gate contact portions 184 in the contact area SA or the pad insulation layer 132i may be substantially the same. That is, positions of the plurality of gate contact portions 184 in the first direction may be substantially the same position in the second direction. For example, positions of a plurality of first gate contact portions, arranged in a first row, in the first direction may be the same as positions of a plurality of second gate contact portions, arranged in a second row different from the first row, in the first direction. The plurality of gate contact portions 184 may be arranged in rows in the first direction Y and in columns in the second direction X as shown in FIG. 5. Thereby, the positions of gate contact portions 184 of each row in the first direction Y may be aligned with the positions of gate contact portions 184 of the other rows in the first direction Y.

Accordingly, the pad insulation layer 132i may have the obtuse angle in a plan view without changing a shape of the edges 130e of the plurality of gate electrodes 130 in the main portion 132s or without changing positions of the plurality of gate contact portions 184 in the main portion 132s.

According to an embodiment, the pad insulation layer 132i may have the gentle slope on the periphery of the corner LC and a defect that may occur on the periphery of the corner LC of the pad insulation layer 132i may be prevented. Particularly, in the structure that includes the stacking structure 120 having the relatively large area as in an embodiment and may be vulnerable to the defect on the periphery of the corner LC of the pad insulation layer 132i, the defect may be effectively prevented by a shape of the pad insulation layer 132i. Thereby, performance and reliability of the semiconductor device 10 may be enhanced.

The gate stacking structure 120g (e.g., the plurality of gate electrodes 130), which has the stair shape, and the pad insulation layer 132i, which covers the gate stacking structure 120g (e.g., the plurality of gate electrodes 130) and has the obtuse angle in a plan view, may be easily formed by changing a shape of a mask used in a process (e.g., an etching process) of forming the recess portion RP.

An example of a manufacturing method of a semiconductor device 10 according to an embodiment will be briefly described.

A first portion of an insulating stacking structure 120s may be formed on a preliminary substrate, a recess portion RP that corresponds to a first pad region PU1 and PL1 may be formed by using a mask, and a pad insulation layer 132i may be formed in the recess portion RP. A second portion of the insulating stacking structure 120s may be formed on the first portion of the insulating stacking structure 120s, a recess portion RP that corresponds to a second pad region PU2 and PL2 may be formed by using a mask, and a pad insulation layer 132i may be formed in the recess portion RP. A channel structure CH that passes through the insulating stacking structure 120s may be formed in at least a partial portion of a cell array region 102. A penetration portion may be formed at a portion that corresponds to a separation structure 146, and sacrificial insulation layers 130s that are disposed in the cell array region 102 and at least a partial portion of the connection region 104 may be selectively removed by using the penetration portion. Gate electrodes 130 may be formed in portions where the sacrificial insulation layers 130s were removed to form a gate stacking structure 120g. A plurality of gate contact portions 184 that are electrically connected to the gate electrodes 130, respectively, in the first pad region PU1 and PL1 and the second pad region PU2 and PL2 may be formed.

A preliminary cell region that is manufactured by the above process may be bonded to a circuit region 200, the preliminary substrate and a gate dielectric layer 150 of a protruding portion CHP may be removed, and a second substrate 110 may be formed.

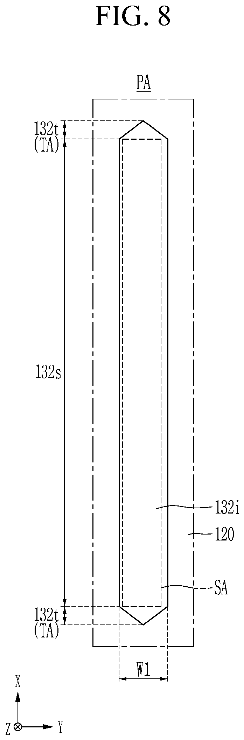

Referring to FIG. 8 to FIG. 17, semiconductor devices according example embodiments will be described in more detail. To the extent that an element is not described in detail below, it may be understood that the element is substantially the same as a corresponding element that has been described elsewhere within the present disclosure. A portion which is not described in the above will be described in detail.

FIG. 8 is a plan view schematically illustrating a pad region included in a semiconductor device according to an example embodiment. FIG. 8 illustrates a portion that corresponds to a left portion of FIG. 5.

Referring to FIG. 8, in an embodiment, a corner of a pad insulation layer 132i may have an obtuse angle in a plan view. In this instance, it is illustrated as an example that a width of an end portion 132t in a first direction may gradually decrease from a first width W1 to zero (0) as it goes from a portion that is adjacent to a main portion 132s to a portion that is far away from the main portion 132s. In a plan view, the pad insulation layer 132i may have a hexagonal shape, and each of the plurality of corners (six corners) of the pad insulation layer 132i may have an obtuse angle. Unless otherwise described the description with reference to FIG. 1 to FIG. 7 may be applied to the pad insulation layer 132i as is.

Thereby, an entire portion of an edge of the end portion 132t may be inclined to an edge of the main portion 132s to have an obtuse angle. In each of corners of a plurality of portions of the pad insulation layer 132i that are disposed on a plurality of gate electrodes having a stair shape, a first side surface of the pad insulation layer 132i and a second side surface of the pad insulation layer 132i may meet to have the obtuse angle. Accordingly, a defect that may occur on a periphery of the corner of the pad insulation layer 132i may be prevented or minimized.

In FIG. 5 or FIG. 8, it is illustrated as an example that the pad insulation layer 132i has an octagonal shape or a hexagonal shape in a plan view and each of the plurality of corners has the obtuse angle. However, the embodiments are not limited thereto. The pad insulation layer 132i may have any of various structures having five or more corners. At least one of a plurality of corners of the pad insulation layer 132i may have an obtuse angle. In some embodiments, at least one of a plurality of corners of the pad insulation layer 132i may have an obtuse angle in a case that the pad insulation layer 132i may include four or less corners.

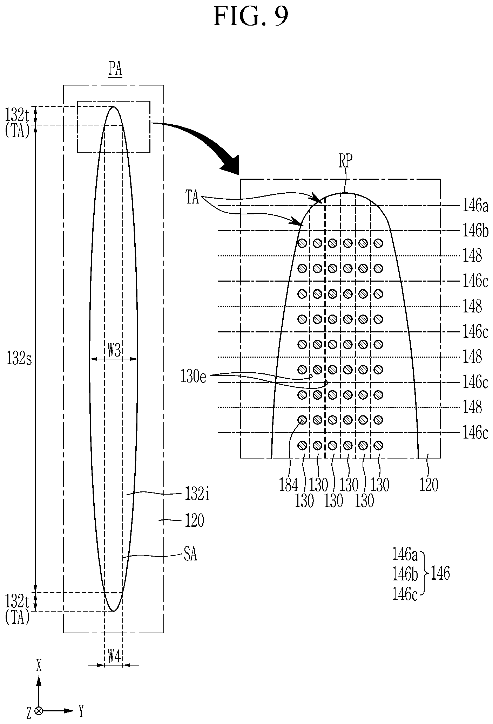

FIG. 9 is a plan view schematically illustrating a pad region included in a semiconductor device according to an example embodiment. FIG. 9 illustrates a portion that corresponds to a left portion of FIG. 5.

Referring to FIG. 9, in an embodiment, a pad insulation layer 132i may include a rounded portion in a plan view.

In an embodiment, a main portion 132s of the pad insulation layer 132i that corresponds to a contact area SA in a second direction (an X-axis direction in the drawings) may include a width changing portion where the width in a first direction changes. For example, each of the main portion 132s and an end portion 132t of the pad insulation layer 132i may include a width changing portion. For example, a width of the contact area SA in a first direction (a Y-axis direction in the drawings) may vary according to a position in the second direction (the X-axis direction in the drawings). For example, the width of the contact area SA may gradually decrease from a third width W3 to a fourth width W4 as it goes from a center of the contact area SA to an end of the contact area SA in the second direction.

In a plan view, an entire portion of an edge of the pad insulation layer 132i may be rounded. In an embodiment, the pad insulation layer 132i may have at least a partial portion of an oval shape in a plan view. In this instance, the pad insulation layer 132i may have a short axis in the first direction (the Y-axis direction in the drawings) and have a long axis in the second direction (the X-axis direction in the drawings). However, the embodiments are not limited thereto.

Thereby, a side surface of the pad insulation layer 132i may include or be formed of a curved surface with an obtuse angle greater than a right angle. Thereby, in at least one of a plurality of portions of the pad insulation layer 132i that are disposed on a plurality of gate electrodes 130, a side surface of the pad insulation layer 132i may include or be formed of a gently curved surface. For example, an entire portion of a lower edge of each of the plurality of portions of the pad insulation layer 132i that are disposed on the plurality of gate electrodes 130 may be rounded. Thereby, a defect that may occur on a periphery of a corner of the pad insulation layer 132i may be effectively prevented.

In an embodiment, a contact area SA may have a rectangular shape that has a predetermined width in the first direction (the Y-axis direction in the drawings) and longitudinally extends in the second direction (the X-axis direction in the drawings). For example, the contact area SA may have a width or an area less than a width or an area of the main portion 132s and may have a shape that is the same as or corresponds to a shape of the main portion 132s.

Each of edges 130e of the plurality of gate electrodes 130 in the contact area SA or the pad insulation layer 132i may longitudinally extend in a direction perpendicular to the first direction (the Y-axis direction of the drawing). That is, each of the edges 130e of the plurality of gate electrodes 130 may be parallel to the second direction (the X-axis direction in the drawings). In this instance, the edges 130e of the plurality of gate electrodes 130 may be parallel to at least one edge of the main portion 132s. More particularly, the edges 130e of the plurality of gate electrodes 130 may be parallel to an edge (a left edge in FIG. 9) of the main portion 132s that is adjacent to a cell array region 102 (refer to FIG. 1) in the first direction.

An interval between a plurality of gate contact portions 184 in the contact area SA or the pad insulation layer 132i may be substantially the same. That is, positions of the plurality of gate contact portions 184 in the first direction may be substantially the same position in the second direction. For example, positions of a plurality of first gate contact portions, arranged in a first row, in the first direction may be the same as positions of a plurality of second gate contact portions, arranged in a second row, in the first direction. In this instance, the second row may be at a position different from a position of the first row in the second direction. The plurality of gate contact portions 184 may be arranged in rows in the first direction Y and in columns in the second direction X as shown in FIG. 9. Thereby, the positions of gate contact portions 184 of each row in the first direction Y may be aligned with the positions of gate contact portions 184 of the other rows in the first direction Y.

Accordingly, the pad insulation layer 132i may have the rounded portion in a plan view without changing a shape of the edges 130e of the plurality of gate electrodes 130 in a pad region PA or without changing positions of the plurality of gate contact portions 184 in the pad region PA.

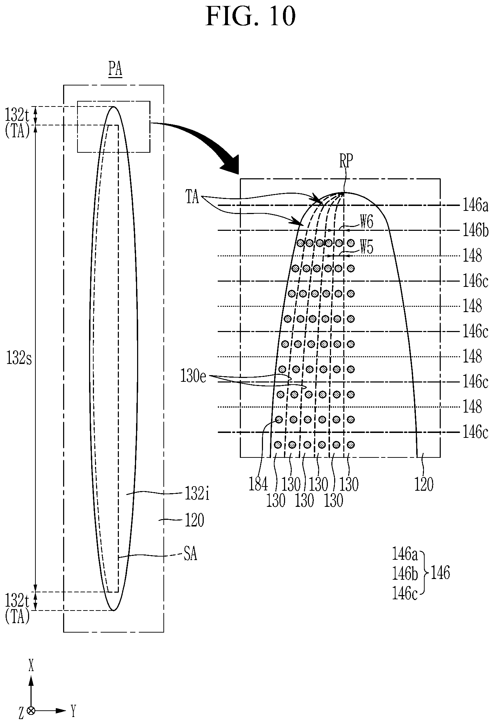

FIG. 10 is a plan view schematically illustrating a pad region included in a semiconductor device according to an example embodiment. FIG. 10 illustrates a portion that corresponds to FIG. 5.

Referring to FIG. 10, in an embodiment, a pad insulation layer 132i may include a rounded portion in a plan view. Unless otherwise described the description with reference to FIG. 9 may be applied to the pad insulation layer 132i as is.

In an embodiment, a first edge (a left edge in FIG. 10) of a contact area SA that is adjacent to a cell array region 102 (refer to FIG. 1) may have a shape that is the same as or corresponds to a shape of a first edge (a left edge in FIG. 10) of a main portion 132s that is adjacent to the cell array region 102. For example, as illustrated in FIG. 10, a first edge of the pad insulation layer 132i (e.g., the main portion 132s) that is adjacent to the cell array region 102 may have a convex rounded shape toward an outside in the first direction, and the first edge (the left edge in FIG. 10) of the contact area SA that is adjacent to the cell array region 102 may have a convex rounded shape toward the outside in the first direction. In FIG. 10, it is illustrated as an example that a second edge (a right edge in FIG. 10) of the contact area SA that is far away from the cell array region 102 is parallel to a second direction. Thereby, in a plan view, the contact area SA may have a shape that corresponds to at least a partial portion of an oval shape in a plan view. However, the embodiments are not limited thereto.

In a plan view, at least one of edges 130e of a plurality of gate electrodes 130 that are disposed in the pad insulation layer 132i may have a portion that is not parallel to each of the first direction and the second direction or have a rounded portion. For example, at least one of the plurality of edges 130e of the plurality of gate electrodes 130 may be rounded so that a length of the gate electrode 130 in the first direction (the Y-axis direction in the drawings) may decrease as it goes from a portion close to an end of the contact area SA toward a center of the contact area SA in the second direction (the X-axis direction in the drawings). In FIG. 10, it is illustrated as an example that a farthest edge 130e of the edges 130e of the gate electrodes 130 that is the farthest from the cell array region 102 is parallel to the second direction, but the embodiments are not limited thereto.

In an embodiment, the edge 130e of the gate electrode 130 may have a shape that corresponds to or is similar to a shape of a first edge (a left edge in FIG. 10) of the main portion 132s that is adjacent to the cell array region 102. For example, as illustrated in FIG. 10, a first edge of the pad insulation layer 132i (e.g., the main portion 132s) that is adjacent to the cell array region 102 may have a convex rounded shape toward an outside in the first direction, and at least one of the plurality of edges 130e of the plurality of gate electrodes 130 may have a convex rounded shape toward the outside in the first direction.

In an embodiment, in at least one of pad portions of the plurality of gate electrodes 130 that correspond to a plurality of gate contact portions 184, a fifth width W5 at a portion close to a center of the pad insulation layer 132i in the second direction (the X-axis direction in the drawings) may be different from a sixth width W6 at a portion close to an end of the pad insulation layer 132i in the second direction. Here, the fifth width W5 or the sixth width W6 may refer to a width in the first direction.

In this instance, the sixth width W6 may be less than the fifth width W5. For example, a width of at least one of pad portions of the plurality of gate electrodes 130 may gradually decrease as it goes from the portion close to the center of the pad insulation layer 132i to the portion close to the end of the pad insulation layer 132i in the second direction. Accordingly, the pad portions of the plurality of gate electrodes 130 may have a shape that corresponds to a shape of the pad insulation layer 132i where a width in the first direction gradually decreases from the center to the end in the second direction.

In an embodiment, the gate contact portions 184 may be arranged considering a shape of the first edge (the left edge in FIG. 10) of the main portion 132s that is adjacent to the cell array region 102. For example, the plurality of gate contact portions 184 may include a plurality of first gate contact portions that are adjacent to each other in the first direction, and a plurality of second gate contact portions that are adjacent to each other in the first direction and are closer to the end of the pad insulation layer 132i than the plurality of first gate contact portions in the second direction (the X-axis direction in the drawings). In this instance, a second interval between the plurality of second gate contact portions may be less than a first interval between the plurality of first gate contact portions. As such, second-direction positions of the plurality of gate contact portions 184 that are adjacent to each other in the first direction may be the same, while first-direction positions of the plurality of gate contact portions 184 that are in different positions in the second direction may be different from each other. The second-direction positions may be positions in the second direction, and the first-direction positions may be positions in the first direction.

In an embodiment, a shape of the edge 130e of the gate electrode 130 and a position of the gate contact portion 184 may be configured to correspond to the shape of the pad insulation layer 132i, and thus, the pad insulation layer 132i may have a relatively small area.

According to an embodiment, an entire portion of a lower edge of each of the plurality of portions of the pad insulation layer 132i that are disposed on the plurality of gate electrodes 130 may be rounded. Thereby, a defect that may occur on a periphery of a corner of the pad insulation layer 132i may be effectively prevented.

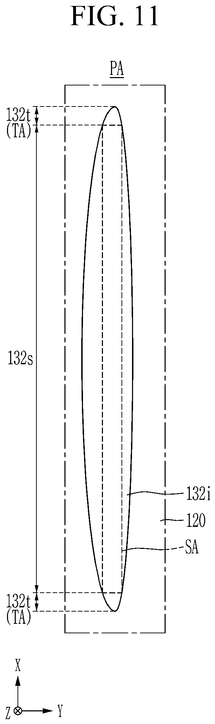

FIG. 11 is a plan view schematically illustrating a pad region included in a semiconductor device according to an example embodiment. FIG. 11 illustrates a portion that corresponds to a left portion of FIG. 5.

Referring to FIG. 11, in an embodiment, a pad insulation layer 132i may include a rounded portion in a plan view. In this instance, both edges of the pad insulation layer 132i in a first direction may be asymmetric from each other.

For example, in a plan view, an entire portion of an edge of the pad insulation layer 132i may be rounded. For example, as illustrated in FIG. 11, a first edge (e.g., a left edge in FIG. 11) of the pad insulation layer 132i that is adjacent to a cell array region 102 (refer to FIG. 1) may have a rounded shape with a relatively small curvature, and a second edge (e.g., a right edge in FIG. 11) of the pad insulation layer 132i that is far away from the cell array region 102 may have a rounded shape with a relatively large curvature. Thereby, a first area of the pad insulation layer 132i where a pad section PS (refer to FIG. 4) is disposed may be sufficiently secured, and a second area of the pad insulation layer 132i where a dummy section DS (refer to FIG. 4) is disposed may be relatively small. Gate electrodes and gate contact portions may be stably connected by sufficiently securing an area of the pad section PS, and an area of the pad insulation layer 132i may be reduced by reducing an area of the dummy section DS.

In FIG. 11, it is illustrated as an example that a contact area SA has a shape that is the same as a shape of a contact area described with reference to FIG. 5 or FIG. 9. Accordingly, the description of a shape or a position of a contact area, gate electrodes, and/or gate contact portions with reference to FIG. 5 or FIG. 9 may be applied as is. However, the embodiments are not limited thereto. In some embodiments, the description of a shape or a position of a contact region, gate electrodes, and/or gate contact portions with reference to FIG. 10 may be applied to an embodiment illustrated in FIG. 11.

In FIG. 11, it is illustrated as an example that the pad insulation layer 132i has a shape that is similar to a shape of a pad insulation layer illustrated in FIG. 9 or FIG. 10 and that both edges of the pad insulation layer 132i are asymmetric to each other. However, the embodiments are not limited thereto. In some embodiments, the pad insulation layer 132i may have a shape that is similar to a shape of a pad insulation layer illustrated in FIG. 5, FIG. 8, FIG. 12, FIG. 13, FIG. 14, FIG. 15, FIG. 16, or FIG. 17 and wherein both edges of the pad insulation layer 132i may be asymmetric to each other. Other various modifications are possible.

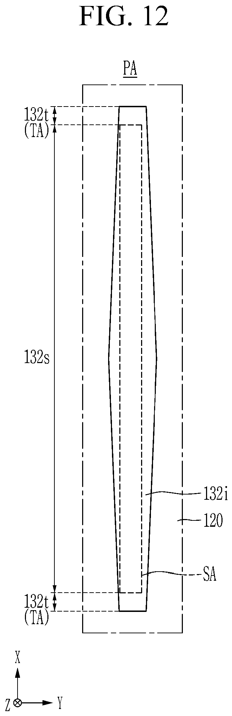

FIG. 12 is a plan view schematically illustrating a pad region included in a semiconductor device according to an example embodiment. FIG. 12 illustrates a portion that corresponds to a left portion of FIG. 5.

Referring to FIG. 12, in an embodiment, a corner of a pad insulation layer 132i may have an obtuse angle in a plan view. In an embodiment, a main portion 132s of the pad insulation layer 132i that corresponds to a contact area SA in a second direction (an X-axis direction in the drawings) may include a width changing portion where the width in a first direction changes. For example, each of the main portion 132s and an end portion 132t of the pad insulation layer 132i may include a width changing portion.

For example, an entire portion of each of both edges of the pad insulation layer 132i in the first direction (the Y-axis direction in the drawings) may be inclined to the first direction in a plan view. For example, both edges of the pad insulation layer 132i in the first direction may have inclined directions that are opposite to each other. More particularly, in a plan view, a first edge (a left edge in FIG. 12) of the pad insulation layer 132i may include a first edge portion and a second edge portion having an obtuse angle, and each of the first edge portion and the second edge portion may be inclined to the first direction and the second direction. More particularly, in a plan view, a second edge (a right edge in FIG. 12) of the pad insulation layer 132i may include a third edge portion and a fourth edge portion having an obtuse angle, and each of the third edge portion and the fourth edge portion may be inclined to the first direction and the second direction. For example, the pad insulation layer 132i may have a hexagonal shape in a plan view.

In FIG. 12, it is illustrated as an example that a width in the main portion 132s and the end portion 132t may gradually decrease from a center of the pad insulation layer 132i to an end of the pad insulation layer 132i in the second direction (the X-axis direction in the drawings). However, the embodiments are not limited thereto. In some embodiments, the width in the main portion 132s and the end portion 132t may gradually increase from the center of the pad insulation layer 132i to the end of the pad insulation layer 132i in the second direction (the X-axis direction in the drawings).

In an embodiment, the contact area SA may have a rectangular shape that has a predetermined width in the first direction (the Y-axis direction in the drawings) and longitudinally extends in the second direction (the X-axis direction in the drawings). For example, the contact area SA may have a width or an area less than a width or an area of the main portion 132s and may have a shape that is the same as or corresponds to a shape of the main portion 132s. Each of the edges of a plurality of gate electrodes in the contact area SA or the pad insulation layer 132i may longitudinally extend in a direction perpendicular to the first direction (the Y-axis direction of the drawing). An interval between a plurality of gate contact portions in the contact area SA or the pad insulation layer 132i may be substantially the same. Accordingly, the description of a shape or a position of a contact area, edges of gate electrodes, and/or gate contact portions with reference to FIG. 5 or FIG. 9 may be applied as is.

Accordingly, the pad insulation layer 132i may have the rounded portion in a plan view without changing a shape of the edges of the plurality of gate electrodes in a pad region PA or without changing positions of the plurality of gate contact portions in the pad region PA.

According to an embodiment, in each of a plurality of portions of the pad insulation layer 132i that are disposed on the plurality of gate electrodes 130, a first side surface of the pad insulation layer 132i and a second side surface of the pad insulation layer 132i may be connected to have an obtuse angle. Thereby, a defect that may occur on a periphery of a corner of the pad insulation layer 132i may be effectively prevented.

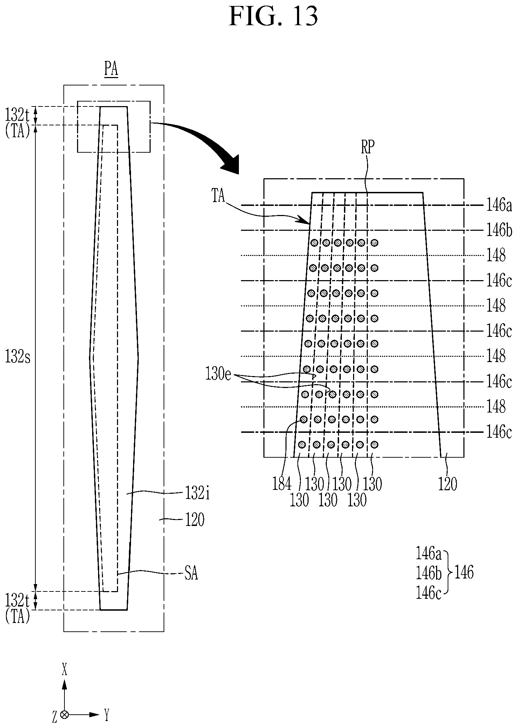

FIG. 13 is a plan view schematically illustrating a pad region included in a semiconductor device according to an example embodiment. FIG. 13 illustrates a portion that corresponds to FIG. 5.

Referring to FIG. 13, in an embodiment, a corner of a pad insulation layer 132i may have an obtuse angle in a plan view. In an embodiment, a main portion 132s of the pad insulation layer 132i that corresponds to a contact area SA in a second direction (an X-axis direction in the drawings) may include a width changing portion where the width in a first direction changes. For example, each of the main portion 132s and an end portion 132t of the pad insulation layer 132i may include a width changing portion.

For example, an entire portion of each of both edges of the pad insulation layer 132i in the first direction (the Y-axis direction in the drawings) may be inclined to the first direction (a Y-axis direction in the drawings) in a plan view. Unless otherwise described the description of a pad insulation layer with reference to FIG. 12 may be applied to the pad insulation layer 132i as is.

In an embodiment, a width of the contact area SA in the first direction (the Y-axis direction in the drawings) may vary according to a position in the second direction (the X-axis direction in the drawings). For example, the width of the contact area SA may gradually decrease as it goes from a center of the contact area SA to an end of the contact area SA in the second direction.

In an embodiment, a first edge (a left edge of FIG. 13) of the contact area SA that is adjacent to a cell array region 102 (refer to FIG. 1) may have a shape that is the same as or corresponds to a shape of a first edge (a left edge of FIG. 13) of the main portion 132s that is adjacent to the cell array region 102. For example, as illustrated in FIG. 13, a first edge of the pad insulation layer 132i (e.g., the main portion 132s) that is adjacent to the cell array region 102 may be inclined to the first direction, and the first edge of the contact area SA that is adjacent to the cell array region 102 may be inclined to have the same inclined direction as the first edge of the pad insulation layer 132i. In FIG. 13, it is illustrated as an example that a second edge (a right edge of FIG. 10) of the contact area SA that is far away from the cell array region 102 is parallel to the second direction. Thereby, the contact area SA may have a pentagonal shape in a plan view. However, the embodiments are not limited thereto.

In a plan view, at least one of edges 130e of a plurality of gate electrodes 130 that are disposed in the pad insulation layer 132i may have a portion that is not parallel to each of the first direction and the second direction (e.g., a portion that is inclined to the first direction). For example, at least one of the plurality of edges 130e of the plurality of gate electrodes 130 may be inclined so that a length of the gate electrode 130 in the first direction (the Y-axis direction in the drawings) may decrease as it goes from a portion close to an end of the contact area SA toward a center of the contact area SA in the second direction (the X-axis direction in the drawings).

In an embodiment, the edge 130e of the gate electrode 130 may have a shape that corresponds to or is similar to a shape of a first edge (a left edge in FIG. 13) of the main portion 132s that is adjacent to the cell array region 102. For example, as illustrated in FIG. 13, a first edge of the pad insulation layer 132i (e.g., the main portion 132s) that is adjacent to the cell array region 102 may be inclined to the first direction, and at least one of the plurality of edges 130e of the plurality of gate electrodes 130 may be inclined to have the same inclined direction as the first edge of the pad insulation layer 132i. In FIG. 13, it is illustrated as an example that a farthest edge 130e of the edges 130e of the gate electrodes 130 that is the farthest from the cell array region 102 is parallel to the second direction, but the embodiments are not limited thereto.

In an embodiment, in at least one of pad portions of the plurality of gate electrodes 130 that correspond to a plurality of gate contact portions 184, a width at a portion close to a center of the pad insulation layer 132i in the second direction (the X-axis direction in the drawings) may be different from a width at a portion close to an end of the pad insulation layer 132i in the second direction.

For example, a width of at least one of pad portions of the plurality of gate electrodes 130 may gradually decrease as it goes from the portion close to the center of the pad insulation layer 132i to the portion close to the end of the pad insulation layer 132i in the second direction. Accordingly, the pad portions of the plurality of gate electrodes 130 may have a shape that corresponds to a shape of the pad insulation layer 132i where a width in the first direction gradually decreases from the center to the end in the second direction.

In an embodiment, the gate contact portions 184 may be arranged considering a shape of the first edge (the left edge in FIG. 13) of the main portion 132s that is adjacent to the cell array region 102. For example, the plurality of gate contact portions 184 may include a plurality of first gate contact portions that are adjacent to each other in the first direction, and a plurality of second gate contact portions that are adjacent to each other in the first direction and are closer to the end of the pad insulation layer 132i than the plurality of first gate contact portions in the second direction (the X-axis direction in the drawings). In this instance, a second interval between the plurality of second gate contact portions may be less than a first interval between the plurality of first gate contact portions. As such, second-direction positions of the plurality of gate contact portions 184 that are adjacent to each other in the first direction may be the same, while first-direction positions of the plurality of gate contact portions 184 that are in different positions in the second direction may be different from each other. The second-direction positions may be positions in the second direction, and the first-direction positions may be positions in the first direction.

In an embodiment, a shape of the edge 130e of the gate electrode 130 and a position of the gate contact portion 184 may be configured to correspond to the shape of the pad insulation layer 132i, and thus, the pad insulation layer 132i may have a relatively small area.

According to an embodiment, in each of corners of a plurality of portions of the pad insulation layer 132i that are disposed on the plurality of gate electrodes having a stair shape, a first side surface of the pad insulation layer 132i and a second side surface of the pad insulation layer 132i may meet to have an obtuse angle. Accordingly, a defect that may occur on a periphery of the corner of the pad insulation layer 132i may be prevented or minimized.

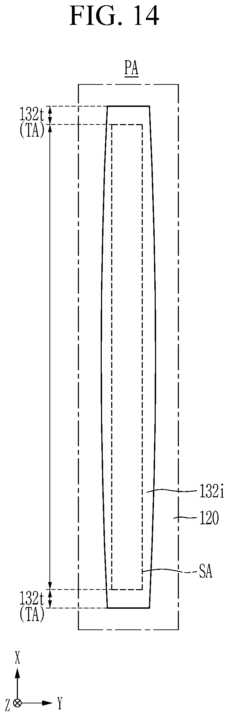

FIG. 14 is a plan view schematically illustrating a pad region included in a semiconductor device according to an example embodiment. FIG. 14 illustrates a portion that corresponds to a left portion of FIG. 5.

Referring to FIG. 14, in an embodiment, a pad insulation layer 132i may include a rounded portion in a plan view. For example, at least one of both edges of the pad insulation layer 132i in a first direction (a Y-axis direction in the drawings) may have a convex rounded shape toward an outside in the first direction. In FIG. 14, it is illustrated as an example that each of both edges of the pad insulation layer 132i in the first direction has the convex rounded shape toward the outside in the first direction.

In a plan view, a main portion 132s of the pad insulation layer 132i illustrated in FIG. 14 may have a shape that is the same as or similar to a shape of a main portion of a pad insulation layer illustrated in FIG. 9, FIG. 10, or FIG. 11. An end of an end portion 132t in the second direction may have a straight line portion that extends in the first direction in a plan view. Thus, the main portion 132s of the pad insulation layer 132i illustrated in FIG. 14 may be different from an end portion 132t of a pad insulation layer 132i that is illustrated in FIG. 9, FIG. 10, or FIG. 11 and includes a curved line without the straight line portion. Unless otherwise described the description with reference to FIG. 9 and FIG. 11 may be applied as is.

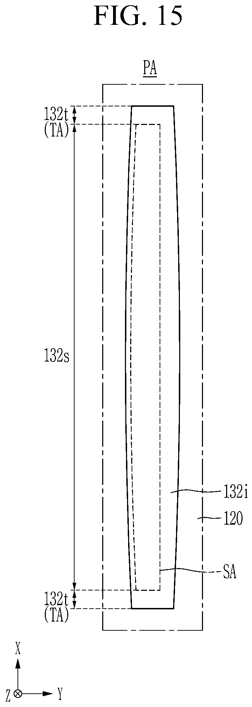

In FIG. 14, it is illustrated as an example that a contact area SA has a shape that is the same as a shape of a contact area described with reference to FIG. 5 or FIG. 9. Accordingly, the description of a shape or a position of a contact area, gate electrodes, and/or gate contact portions with reference to FIG. 5 or FIG. 9 may be applied as is. However, the embodiments are not limited thereto. In some embodiments, as illustrated in FIG. 15, the contact area SA may have a shape that is the same as the shape of a contact area described with reference to FIG. 10. Accordingly, the description of a shape or a position of a contact area, gate electrodes, and/or gate contact portions with reference to FIG. 10 may be applied as is.

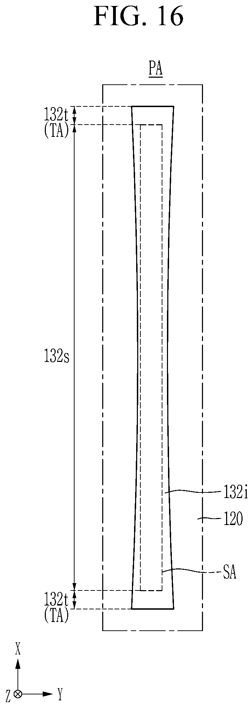

FIG. 16 is a plan view schematically illustrating a pad region included in a semiconductor device according to an example embodiment. FIG. 16 illustrates a portion that corresponds to a left portion of FIG. 5.

Referring to FIG. 16, in an embodiment, a pad insulation layer 132i may include a rounded portion in a plan view. For example, at least one of both edges of the pad insulation layer 132i in a first direction (a Y-axis direction in the drawings) may have a convex rounded shape toward an inside in the first direction. In FIG. 16, it is illustrated as an example that each of both edges of the pad insulation layer 132i in the first direction has the convex rounded shape toward the inside in the first direction. In this instance, an end of an end portion 132t in a second direction may have a straight line portion that extends in the first direction in a plan view.

In FIG. 16, it is illustrated as an example that a contact area SA has a shape the same as a shape of a contact area described with reference to FIG. 5 or FIG. 9. Accordingly, the description of a shape or a position of a contact area, gate electrodes, and/or gate contact portions with reference to FIG. 5 or FIG. 9 may be applied as is. However, the embodiments are not limited thereto.

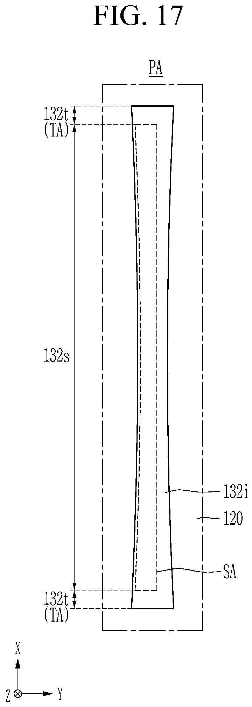

In some embodiments, as illustrated in FIG. 17, a width of a contact area SA in a first direction (a Y-axis direction in the drawings) may vary according to a position in a second direction (an X-axis direction in the drawings). For example, the width of the contact area SA may gradually decrease as it goes from a center of the contact area SA to an end of the contact area SA in the second direction.

In an embodiment, a first edge (a left edge in FIG. 17) of the contact area SA that is adjacent to a cell array region 102 (refer to FIG. 1) may have a shape that is the same as or corresponds to a shape of a first edge (a left edge in FIG. 17) of a main portion 132s that is adjacent to the cell array region 102. For example, as illustrated in FIG. 17, a first edge of the pad insulation layer 132i (e.g., the main portion 132s) that is adjacent to the cell array region 102 may have a convex rounded shape toward an inside in the first direction, and the first edge (the left edge in FIG. 17) of the contact area SA that is adjacent to the cell array region 102 may have a convex rounded shape toward the inside in the first direction. In FIG. 17, it is illustrated as an example that a second edge (a right edge in FIG. 17) of the contact area SA that is far away from the cell array region 102 is parallel to the second direction. However, the embodiments are not limited thereto.

In a plan view, at least one of edges of a plurality of gate electrodes that are disposed in the pad insulation layer 132i may have a portion that is not parallel to each of the first direction and the second direction or have a rounded portion. For example, at least one of the plurality of edges of the plurality of gate electrodes may be rounded so that a length of the gate electrode in the first direction (the Y-axis direction in the drawings) may decrease as it goes from a portion close to an end of the contact area SA toward a center of the contact area SA in the second direction (the X-axis direction in the drawings).

In an embodiment, the edge of the gate electrode may have a shape that corresponds to or is similar to a shape of a first edge (a left edge in FIG. 17) of the main portion 132s that is adjacent to the cell array region 102. For example, as illustrated in FIG. 17, a first edge of the pad insulation layer 132i (e.g., the main portion 132s) that is adjacent to the cell array region 102 may have a convex rounded shape toward an inside in the first direction, and at least one of the plurality of edges 130e of the plurality of gate electrodes 130 may have a convex rounded shape toward the inside in the first direction. A farthest edge of the edges of the gate electrodes that is the farthest from the cell array region 102 may be parallel to the second direction.

In an embodiment, in at least one of pad portions of the plurality of gate electrodes that correspond to the plurality of gate contact portions, a width at a portion close to a center of the pad insulation layer 132i in the second direction (the X-axis direction in the drawings) may be different from a width at a portion close to an end of the pad insulation layer 132i in the second direction.

For example, a width of at least one of pad portions of the plurality of gate electrodes may gradually decrease as it goes from the portion close to the center of the pad insulation layer 132i to the portion close to the end of the pad insulation layer 132i in the second direction. Accordingly, the pad portions of the plurality of gate electrodes may have a shape that corresponds to a shape of the pad insulation layer 132i where a width in the first direction gradually decreases from the center to the end in the second direction.

In an embodiment, the gate contact portions may be arranged considering a shape of the first edge (the left edge in FIG. 17) of the main portion 132s that is adjacent to the cell array region 102. For example, the plurality of gate contact portions may include a plurality of first gate contact portions that are adjacent to each other in the first direction, and a plurality of second gate contact portions that are adjacent to each other in the first direction and are closer to the end of the pad insulation layer 132i than the plurality of first gate contact portions in the second direction (the X-axis direction in the drawings). In this instance, a second interval between the plurality of second gate contact portions may be greater than a first interval between the plurality of first gate contact portions. As such, second-direction positions of the plurality of gate contact portions 184 that are adjacent to each other in the first direction may be the same, while first-direction positions of the plurality of gate contact portions 184 that are in different positions in the second direction may be different from each other. The second-direction positions may be positions in the second direction, and the first-direction positions may be positions in the first direction.

In an embodiment, a shape of the edge of the gate electrode and a position of the gate contact portion may be configured to correspond to the shape of the pad insulation layer 132i, and thus, the pad insulation layer 132i may have a relatively small area.

According to an embodiment, an entire portion of a lower edge of each of a plurality of portions of the pad insulation layer 132i that are disposed on the plurality of gate electrodes 130 may be rounded. Thereby, a defect that may occur on a periphery of a corner of the pad insulation layer 132i may be effectively prevented.

An example of an electronic system including the semiconductor device will be described in detail below.

FIG. 18 schematically illustrates an electronic system including a semiconductor device according to an example embodiment.

Referring to FIG. 18, an electronic system 1000 according to an embodiment may include a semiconductor device 1100 and a controller 1200 electrically connected to the semiconductor device 1100. The electronic system 1000 may be a storage device including one or a plurality of semiconductor devices 1100 or an electronic device including the storage device. For example, the electronic system 1000 may be a solid-state drive (SSD) device, a universal serial bus (USB), a computing system, a medical device, or a communication device including one or a plurality of semiconductor devices 1100.

The semiconductor device 1100 may be a non-volatile memory device, and for example, may be a NAND flash memory device described with reference to FIG. 1 to FIG. 17. The semiconductor device 1100 may include a first structure 1100F and a second structure 1100S on the first structure 11 OOF. In some embodiments, the first structure 11 OOF may be next to the second structure 1100S. The first structure 11 OOF may be a peripheral circuit structure including a decoder circuit 1110, a page buffer 1120, and a logic circuit 1130. The second structure 1100S may be a memory cell structure including a bit line BL, a common source line CSL, a word line WL, first and second gate upper lines UL1 and UL2, first and second gate lower lines LL1 and LL2, and a memory cell string CSTR between the bit line BL and the common source line CSL.

In the second structure 1100S, each of memory cell strings CSTR may include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. A number of the lower transistors LT1 and LT2 and a number of the upper transistors UT1 and UT2 may be variously modified according to an embodiment.

In an embodiment, the lower transistors LT1 and LT2 may include a ground selection transistor, and the upper transistors UT1 and UT2 may include a string selection transistor. The first and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines UL1 and UL2 may be electrically connected to the decoder circuit 1110 through a first connection wiring 1115 extending to the second structure 1100S within the first structure 1100F. The bit line BL may be electrically connected to the page buffer 1120 through a second connection wiring 1125 extending to the second structure 1100S within the first structure 1100F.

In the first structure 11 OOF, the decoder circuit 1110 and the page buffer 1120 may execute a control operation for at least one memory cell transistor selected from the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection wiring 1135 extending to the second structure 1100S within the first structure 1100F.

The controller 1200 may include a processor 1210, a NAND controller 1220, and a host interface 1230. According to an embodiment, the electronic system 1000 may include a plurality of semiconductor devices 1100, and in this case, the controller 1200 may control the plurality of semiconductor devices 1100.

The processor 1210 may control an overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that processes communication with the semiconductor device 1100. A control command for controlling the semiconductor device 1100, data to be written in the memory cell transistor MCT of the semiconductor device 1100, and data to be read from the memory cell transistor MCT of the semiconductor device 1100, or so on may be transmitted through the NAND interface 1221. The host interface 1230 may provide a communication function between the electronic system 1000 and an external host. When a control command is received from the external host through the host interface 1230, the processor 1210 may control the semiconductor device 1100 in response to the control command.

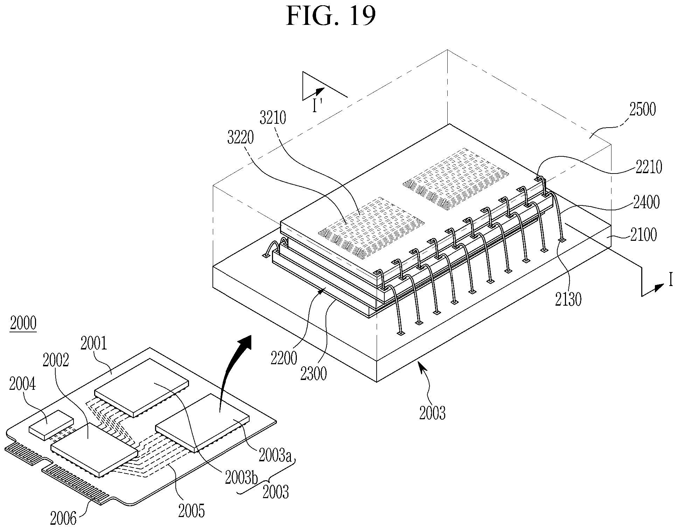

FIG. 19 is a perspective view schematically illustrating an electronic system including a semiconductor device according to an example embodiment.

Referring to FIG. 19, an electronic system 2000 according to an embodiment may include a main substrate 2001, a controller 2002 on the main substrate 2001, one or more semiconductor packages 2003, and a DRAM 2004. The semiconductor package 2003 and the DRAM 2004 may be connected to the controller 2002 through a wiring pattern 2005 at the main substrate 2001.

The main substrate 2001 may include a connector 2006 including a plurality of pins coupled to the external host. A number and an arrangement of the plurality of pins in the connector 2006 may vary depending on a communication interface between the electronic system 2000 and the external host. In an embodiment, the electronic system 2000 may communicate with the external host according to any one of interfaces such as a universal serial bus (USB), a peripheral component interconnect express (PCI-Express), a serial advanced technology attachment (SATA), and an M-Phy for a universal flash storage (UFS). In an embodiment, the electronic system 2000 may operate by power supplied from the external host through the connector 2006. The electronic system 2000 may further include a power management integrated circuit (PMIC) that distributes the power supplied from the external host to the controller 2002 and the semiconductor package 2003.

The controller 2002 may write data in the semiconductor package 2003 or may read data from the semiconductor package 2003, and may improve an operating speed of the electronic system 2000.

The DRAM 2004 may be a buffer memory for mitigating or buffering a speed difference between the semiconductor package 2003, which is a data storage space, and the external host. The DRAM 2004 included in the electronic system 2000 may also be a kind of cache memory, and may also provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chip 2200 on the package substrate 2100, an adhesive layer 2300 at a lower surface of each semiconductor chip 2200, a connection structure 2400 electrically connecting the semiconductor chip 2200 and the package substrate 2100, and a molding layer 2500 covering the semiconductor chip 2200 and the connection structure 2400 on the package substrate 2100.

The package substrate 2100 may be a printed circuit board including a package upper pad 2130. Each semiconductor chip 2200 may include an input/output pad 2210. The input/output pad 2210 may correspond to the input/output pad 1101 of FIG. 18. Each semiconductor chip 2200 may include a gate stacking structure 3210 and a channel structure 3220. The semiconductor chip 2200 may include the semiconductor device described with reference to FIG. 1 to FIG. 17.

In an embodiment, the connection structure 2400 may be a bonding wire electrically connecting the input/output pad 2210 and the package upper pad 2130. Accordingly, in each of the first and second semiconductor packages 2003a and 2003b, the semiconductor chips 2200 may be electrically connected to each other using a bonding wire type, and the semiconductor chip 2200 may be electrically connected to a package upper pad 2130 of the package substrate 2100. According to an embodiment, in each of the first and second semiconductor packages 2003a and 2003b, the semiconductor chips 2200 may be electrically connected to each other by a connection structure including a through silicon via (TSV) instead of the connection structure 2400 using the bonding wire type.

In an embodiment, the controller 2002 and the semiconductor chip 2200 may be included in one package. For example, the controller 2002 and the semiconductor chip 2200 may be mounted on a separate interposer substrate that is different from the main substrate 2001, and the controller 2002 and the semiconductor chip 2200 may be connected to each other by a wiring at the interposer substrate.

FIG. 20 is a cross-sectional view schematically illustrating semiconductor package according to an example embodiment. FIG. 20 illustrates an embodiment of the semiconductor package 2003 of FIG. 19, and conceptually illustrates a region obtained by cutting the semiconductor package 2003 of FIG. 19 along a line I-I'.

Referring to FIG. 20, in the semiconductor package 2003, the package substrate 2100 may be a printed circuit board. The package substrate 2100 may include a package substrate body portion 2120, a package upper pad 2130 at an upper surface of the package substrate body portion 2120, a package lower pad 2125 disposed at a lower surface of the package substrate body portion 2120 or exposed through the lower surface of the package substrate body portion 2120, and an internal wiring 2135 electrically connecting the package upper pad 2130 and the package lower pad 2125 inside the package substrate body portion 2120. The package upper pad 2130 may be electrically connected to the connection structure 2400. The package lower pad 2125 may be connected to a wiring pattern 2005 of the main substrate 2001 of the electronic system 2000, as illustrated in FIG. 19, through a conductive connection portion 2800.

In a semiconductor package 2003, each semiconductor chip 2200 may include a semiconductor substrate 4010, a first structure 4100 on the semiconductor substrate 4010, and a second structure 4200 disposed on the first structure 4100 and bonded to the first structure 4100 by a wafer bonding type.

The first structure 4100 may include a peripheral circuit region including a peripheral wiring 4110 and a first bonding structure 4150. The second structure 4200 may include a common source line 4205, a gate stacking structure 4210 between the common source line 4205 and the first structure 4100, a channel structure 4220 and a separation structure 4230 passing through the gate stacking structure 4210, and a second bonding structure 4250 electrically connected to the channel structure 4220 and a word line WL (refer to FIG. 18) of the gate stacking structure 4210. For example, the second bonding structure 4250 may be electrically connected to the channel structure 4220 and the word line WL through a bit line 4240 electrically connected to the channel structure 4220 and a gate connection wiring electrically connected to the word line WL. The first bonding structure 4150 of the first structure 4100 and the second bonding structure 4250 of the second structure 4200 may be in contact with and bonded to each other. For example, portions of the first bonding structure 4150 and the second bonding structure 4250 where the first bonding structure 4150 and the second bonding structure 4250 are bonded may include copper (Cu).

In an embodiment, a pad insulation layer may have a gentle slope on a periphery of a corner and a defect that may occur on the periphery of the corner of the pad insulation layer may be prevented. Particularly, in a structure that includes a stacking structure having a relatively large area and may be vulnerable to the defect on the periphery of the corner of the pad insulation layer, the defect may be effectively prevented by a shape of the pad insulation layer. Thereby, performance and reliability of a semiconductor device may be enhanced.

Each of the semiconductor chips 2200 may further include an input/output pad 2210 and an input/output connection wiring 4265 at a lower portion of the input/output pad 2210. The input/output connection wiring 4265 may be electrically connected to a part of the second bonding structure 4250.

In an embodiment, in the semiconductor package 2003, a plurality of semiconductor chips 2200 may be electrically connected to each other by the connection structure 2400 having a bonding wire type. In some embodiments, the plurality of semiconductor chips 2200 or a plurality of portions constituting the plurality of semiconductor chips 2200 may be electrically connected by a connection structure including a through silicon via (TSV).

While some examples have been described in connection with what is presently considered to be some practical embodiments, it is to be understood that the disclosure is not limited to the disclosed embodiments, and that that the disclosure is intended to cover various modifications and equivalent arrangements included within the scope of the appended claims.

## Claims

1. A semiconductor device, comprising:
a cell region (100) that includes a cell array region (102) and a connection region (104),
wherein the cell region (100) includes:
a gate stacking structure (102g) including a plurality of interlayer insulation layers (132m) and a plurality of gate electrodes (130) alternately stacked and extending in a first direction;
a channel structure (CH) that passes through the gate stacking structure (102g) in the cell array region (102);
a pad insulation layer (132i) that is disposed in a recess portion (RP) where a partial portion of the gate stacking structure (102g) is removed to expose pad portions of the plurality of gate electrodes (130) in the connection region (104); and
a plurality of gate contact portions (184) that pass through the pad insulation layer (132i) and are electrically connected to the plurality of gate electrodes (130), respectively, and
wherein, in a plan view, the pad insulation layer (132i) includes a corner (LC) having an obtuse angle or the pad insulation layer (132i) includes a rounded portion.

2. The semiconductor device of claim 1, wherein, in at least one of a plurality of portions of the pad insulation layer (132i) that are disposed on the plurality of gate electrodes (130), a first side surface of the pad insulation layer (132i) and a second side surface of the pad insulation layer (132i) are connected to have an obtuse angle.

3. The semiconductor device of claim 1 or 2,
wherein the pad insulation layer (132i) includes a plurality of corners in the plan view, and
wherein each of the plurality of corners has an obtuse angle in the plan view.

4. The semiconductor device of claim 3, wherein the pad insulation layer (132i) includes six or more corners in the plan view.

5. The semiconductor device of any one of claims 1 to 4,
wherein the pad insulation layer (132i) includes a main portion (132s) and an end portion (132t),
wherein the main portion (132s) has a first width in the first direction and longitudinally extends in a second direction that is perpendicular to the first direction, and
wherein the end portion (132t) has a width in the first direction that gradually decreases.

6. The semiconductor device of any one of claims 1 to 4,
wherein the pad insulation layer (132i) includes a main portion (132s) that corresponds to a contact area where the plurality of gate contact portions (184) are disposed in a second direction that is perpendicular to the first direction, and
wherein the main portion (132s) of the pad insulation layer (132i) includes a width changing portion where a width in the first direction changes.

7. The semiconductor device of any one of claims 1 to 6, wherein the pad insulation layer (132i) has at least a partial portion of an oval shape or at least one edge of the pad insulation layer (132i) has a convex shape toward an outside or toward an inside in the plan view.

8. The semiconductor device of any one of claims 1 to 7,
wherein the cell region (100) includes a plurality of separation structures (146) that pass through the gate stacking structure (102g) and extend in the first direction,
wherein an outermost separation structure (146a) of the plurality of separation structures (146) and a first inner separation structure (146b) that is adjacent to the outermost separation structure (146a) cross the pad insulation layer (132i) in the plan view, and
wherein a dummy region (TA) where the channel structure (CH) or the plurality of gate contact portions (184) are not positioned is disposed outside of the outermost separation structure (146a) or between the outermost separation structure (146a) and the first inner separation structure (146b).

9. The semiconductor device of any one of claims 1 to 7,
wherein the cell region (100) includes a plurality of separation structures (146) that pass through the gate stacking structure (102g) and extend in the first direction,
wherein an end portion (132t) of the pad insulation layer (132i) in a second direction that is perpendicular to the first direction includes a width changing portion where a width changes, and
wherein an outermost separation structure (146a) of the plurality of separation structures (146) in the second direction crosses the width changing portion in the plan view.

10. The semiconductor device of any one of claims 1 to 9, wherein an edge of at least one of the plurality of gate electrodes (130) has a portion that is inclined to the first direction or a rounded portion in the plan view.

11. The semiconductor device of any one of claims 1 to 10, wherein, in the plan view, in at least one of the pad portions of the plurality of gate electrodes (130), a width of a portion close to a center of the pad insulation layer (132i) in a second direction that is perpendicular to the first direction is different from a width of another portion close to an end of the pad insulation layer (132i) in the second direction.

12. The semiconductor device of any one of claims 1 to 11,
wherein the plurality of gate contact portions (184) include a plurality of first gate contact portions that are adjacent to each other in the first direction, and a plurality of second gate contact portions that are adjacent to each other in the first direction and are closer to an end of the pad insulation layer (132i) than the plurality of first gate contact portions in a second direction that is perpendicular to the first direction, and
wherein a first interval between the plurality of first gate contact portions in the first direction is different from a second interval between the plurality of second gate contact portions in the first direction.

13. The semiconductor device of any one of claims 1 to 12, wherein the semiconductor device is a bonding semiconductor device that further includes a circuit region (200) bonded to the cell region (100).

14. The semiconductor device of any one of claims 1 to 13,
wherein the gate stacking structure (102g) or an insulating stacking structure (102s) is entirely in the cell array region (102) and in the connection region (104) except for the pad insulation layer (132i), and
wherein the insulating stacking structure (102s) includes the plurality of interlayer insulation layers (132m) and a plurality of sacrificial insulation layers (130s) that are alternately stacked, and the plurality of sacrificial insulation layers (130s) include a material different from a material of the plurality of interlayer insulation layers (132m).

15. The semiconductor device of any one of claims 1 to 13,
wherein the semiconductor device includes a chip region (CA) and a scribe region (DA) outside the chip region (CA), and
wherein an insulating stacking structure (102s) is disposed in the scribe region (DA), the insulating stacking structure (102s) includes the plurality of interlayer insulation layers (132m) and a plurality of sacrificial insulation layers (130s) that are alternately stacked, and the plurality of sacrificial insulation layers (130s) include a material different from a material of the plurality of interlayer insulation layers (132m).
